(19) Europäisches Patentamt
European Patent Office
Office européen des brevets

(11) **EP 4 097 845 B1**

(12) **EUROPEAN PATENT SPECIFICATION**

(45) Date of publication and mention
of the grant of the patent:
**29.07.2026  Bulletin 2026/31**

(21) Application number: **20717797.3**

(22) Date of filing: **31.03.2020**

(51) International Patent Classification (IPC):
*H03M 1/06* *(2006.01)*        *H03M 1/12* *(2006.01)*

(52) Cooperative Patent Classification (CPC):
**H03M 1/0678; H03M 1/123; H03M 1/124**

(86) International application number:
**PCT/EP2020/059076**

(87) International publication number:
**WO 2021/197582 (07.10.2021 Gazette 2021/40)**

(54) **ANALOG-TO-DIGITAL CONVERTER DEVICE**

ANALOG-DIGITAL-WANDLER

DISPOSITIF DE CONVERTISSEUR ANALOGIQUE-NUMÉRIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**07.12.2022  Bulletin 2022/49**

(73) Proprietor: **Huawei Technologies Co., Ltd.
Shenzhen, Guangdong 518129 (CN)**

(72) Inventors:
• **GARCIA ORDONEZ, Luis**
 **80992 Munich (DE)**
• **GUILLAUD, Maxime**
 **80992 Munich (DE)**
• **YANG, Ganghua**
 **80992 Munich (DE)**

(74) Representative: **Gill Jennings & Every LLP
The Broadgate Tower
20 Primrose Street
London EC2A 2ES (GB)**

(56) References cited:
**US-B1- 9 667 325**

• **ORDONEZ LUIS G ET AL: "Integer forcing
analog-to-digital conversion for massive MIMO
systems", 2016 50TH ASILOMAR CONFERENCE
ON SIGNALS, SYSTEMS AND COMPUTERS,
IEEE, 6 November 2016 (2016-11-06), pages 11 -
15, XP033072570, DOI: 10.1109/
ACSSC.2016.7868984**

EP 4 097 845 B1

**Description**

<u>TECHNICAL FIELD</u>

The present disclosure relates to an analog-to-digital converter (ADC) device and a method for analog-to-digital conversion. The disclosure relates generally to the field of digital signal processing and telecommunications. More specifically, the disclosure relates to techniques for improving the accuracy of analog-to-digital conversion of a plurality of analog input signals using individual analog-to-digital converters of lower accuracy.

<u>BACKGROUND</u>

Applying digital signal processing algorithms to a plurality of analog input signals requires an interface between the analog signals and the digital signal processor. The analog signals are sampled and quantized using an analog-to-digital conversion (ADC) unit to create the digital inputs required by any digital signal processing unit. If the analog input signals are sampled at Nyquist rate or above and quantized with very high precision, then the effects of the ADC unit are negligible, since the digital signals reconstructed at the digital signal processing (DSP) unit from the ADC outputs approximate the analog input signals with negligible distortion.

In some applications very high-precision analog-to-digital converters are not cost and/or power-efficient or not even feasible using current technology. This is the case of analog-to-digital conversion of wideband multi-GHz analog signals. Indeed, current ADC technology working at very high sampling rates and high resolution is limited by the timing (or aperture) jitter, i.e., the failure to sample at precisely defined times. In particular, electronic-based ADCs cannot achieve timing jitters smaller than one femtosecond and, hence, photonic-based ADC architectures are used to meet the strict timing jitter required by sampling frequencies in the order of tens of GHz. Still, wideband ADCs with very high resolution are challenging even theoretically. Indeed, the accuracy is strictly below 8 bits, and this is not enough in some applications. For instance, it cannot guarantee the high-order modulations required in envisioned THz wireless communications to support very high throughputs.

US 9667325 B1 describes receiver device, including receiving antennas, radio frequency receivers, a configurable precision analog-to-digital converter, a switch device, a baseband processor, and an analog-to-digital controller. The switch device converts a first number of baseband analog signals into a second number of baseband analog signals. The configurable precision analog-to-digital converter converts the second number of baseband analog signals into a third number of first baseband digital signals. The configurable precision analog-to-digital converter combines at least two of first analog-to-digital converters into at least one second analog-to-digital converter so that the total number of the rest of the first analog-to-digital converters and the at least one second analog-to-digital converters is equal to the third number.

The resolution of each of the second analog-to-digital converters is higher than the resolution of each of the first analog-to-digital converters.

DOI: 10.1109/ACSSC.2016.7868984, discusses the problem that the large number of analog received signals to be processed in massive MIMO systems renders conventional high-precision analog-to-digital conversion (ADC) not feasible in terms of cost- and power-efficiency. The paper presents a novel ADC architecture inspired by the principles of integer-forcing source coding, which jointly reconstructs the received signals in the digital domain. This scheme effectively exploits the correlation among the received signals in order to increase the achievable uplink transmission rates with respect to conventional ADC units in the low-resolution regime.

<u>SUMMARY</u>

It is an objective of the disclosure to provide a novel ADC architecture for solving the above described problems. In particular, it is an objective to improve the accuracy of analog-to-digital conversion for wideband ADCs with very high resolution that may be applied for wideband multi-GHz analog signals.

The disclosure describes a solution how to overcome the limitations described above by introducing a novel ADC architecture, which includes additional analog processing of the analog inputs before the ADCs and alternative digital signal processing of the digital outputs. As a result, the disclosed architecture achieves a higher "effective" accuracy than the nominal accuracies of the individual ADCs used to quantize the input signals.

The disclosure presents an apparatus and a method for increasing the accuracy of analog-to-digital conversion of a plurality of analog signals by effectively creating and exploiting correlation between the analog signals to be converted. This results in higher effective accuracies than the ones obtained with a conventional ADC architecture and state-of-the-art individual ADCs. The required correlation is not assumed to be already present in the analog inputs signals but is internally created at the ADC unit.

According to a first aspect, the disclosure relates to an analog-to-digital converter, ADC, device, comprising: an analog mixer, configured to compute linear combinations of a first plurality of analog input signals based on a set of analog mixing parameters to provide a second plurality of correlated analog signals; an analog-to-digital-converter, configured to convert the second plurality of correlated analog signals to a digital representation of the second plurality of correlated analog signals based on a set of modulo-ADC parameters; and a digital estimator, configured to convert the digital representation of the second plurality of correlated analog signals to a digital representation of the first plurality of analog input signals based on the set of analog mixing parameters and the set of modulo-ADC parameters; wherein the set of modulo-ADC parameters is based on a correlation of the second plurality of correlated analog signals.

Such ADC device can be used as wideband ADC with very high resolution that may be applied for wideband multi-GHz analog signals. The ADC device achieves a higher "effective" accuracy than the nominal accuracies of the individual ADCs used to quantize the input signals.

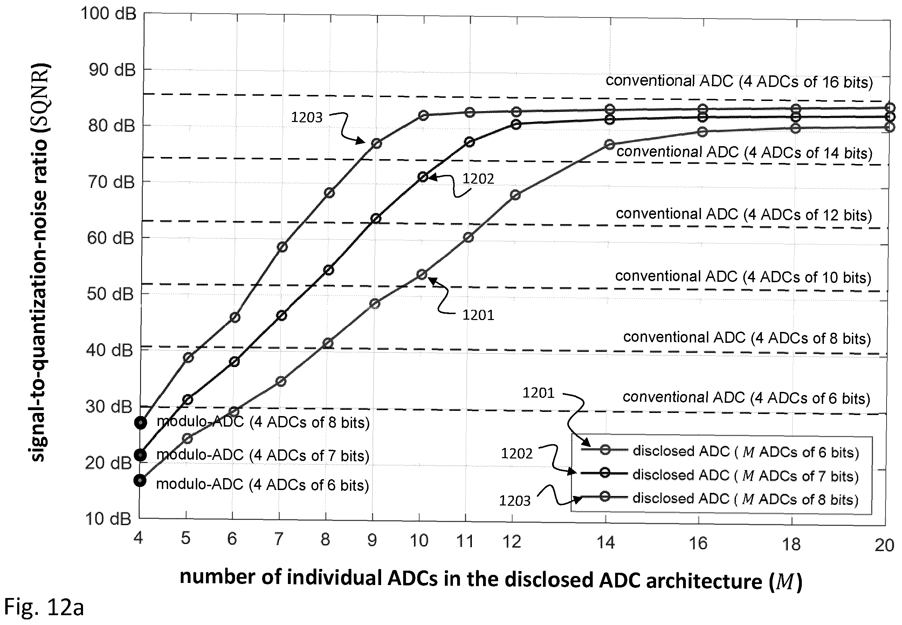

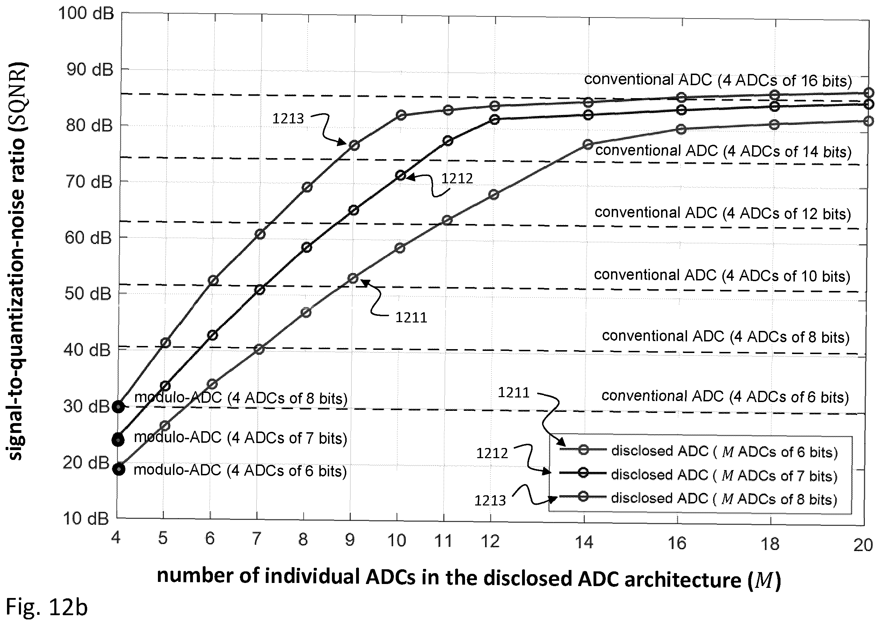

Such ADC device obtains accuracy gains, as shown in Figures 12a and 12b, coming from a particular combination of blocks and not only from increasing the number of individual ADCs. The effective accuracy achieved by such ADC device depends on the number of individual ADCs and their resolution. The performance of the ADC device is robust to the exact correlation of the analog inputs and does not require to estimate it.

The analog mixer in this disclosure is a device or circuit configured to combine electrical or electronic signals into composite output signals.

The analog mixer is also referred to as analog mixing circuit or analog mixing circuitry or analog mixing processing circuitry. The analog mixer correlates the first plurality of analog input signals based on the set of analog mixing parameters and provides a second plurality of correlated analog signals.

The analog-to-digital-converter may also be referred to as analog-to-digital-conversion (ADC) circuit or ADC circuitry or ADC processing circuitry. The analog-to-digital-converter converts the second plurality of correlated analog signals to the digital representation of the second plurality of correlated analog signals based on the set of modulo-ADC parameters. The analog-to-digital-converter may be implemented by a processor.

The digital estimator is also referred to as digital estimation circuit or digital estimation circuitry or digital estimation processing circuitry. The digital estimator converts the digital representation of the second plurality of correlated analog signals to the digital representation of the first plurality of analog input signals based on the set of analog mixing parameters and the set of modulo-ADC parameters. The digital estimator may be implemented by a processor, e.g. a digital signal processor.

The modulo-ADC parameters may be pre-defined and set offline or may be provided during operation, i.e. online.

In an exemplary implementation form of the ADC device, the ADC device comprises a digital controller configured to provide the parameters, in particular the set of analog mixing parameters and/or the set of modulo-ADC parameters.

By using such digital controller, the parameters can be flexibly provided and adjusted by the digital controller if necessary. Alternatively, preconfigured parameters or fixed parameters may be used.

The analog mixing parameters are the multiplicative factors of the linear combination. The analog mixing parameters may be provided as a mixing matrix, for example such that the second plurality (M) of correlated analog signals (402) results from a matrix multiplication of the $N$ analog inputs with the mixing matrix.

Additionally, or alternatively, the $N$ analog inputs may be correlated due to transmission over a physical channel. In an exemplary implementation, the $N$ analog inputs are received by an antenna array. In this case (where the $N$ analog inputs are already correlated), the analog mixing parameters may be used for providing an additional correlation of the correlated analog signals 402 or may alternatively be omitted.

In an exemplary implementation form of the ADC device, the second plurality of correlated analog signals is larger than the first plurality of analog input signals.

This provides the technical advantage that a higher correlation can be implemented between the plurality of correlated analog signals, thereby improving accuracy of the AD conversion.

In an exemplary implementation form of the ADC device, the analog mixer is configured to generate the second plurality of correlated analog signals based on linear combinations of the first plurality of analog input signals by using the set of analog mixing parameters.

This provides the technical advantage that a correlation between the plurality of correlated analog signals can be easily adjusted.

The analog mixing parameters are the multiplicative factors of the linear combination of the analog input signals.

In an exemplary implementation form of the ADC device, the set of modulo-ADC parameters is based on a deviation of the digital representation of the first plurality of analog input signals from the first plurality of analog input signals.

By using such an ADC device, an adaptive algorithm can be applied to control the AD conversion converging to a minimal deviation or distortion.

In an exemplary implementation form of the ADC device, the analog-to-digital-converter is configured to process the second plurality of correlated analog signals based on a set of amplifier gains applied to the second plurality of correlated analog signals, wherein the set of amplifier gains is based on the set of modulo-ADC parameters.

This provides the advantage that the amplifier gains can be used to adjust the dynamic range for each correlated analog signal in order to improve the accuracy of the digital estimation.

In an exemplary implementation form of the ADC device, the analog-to-digital-converter is configured to process the second plurality of correlated analog signals based on a set of dither signals applied to the amplified second plurality of correlated analog signals, wherein the set of dither signals is generated by the analog-to-digital-converter.

Dither can be defined as an intentionally applied form of noise used to randomize quantization error. By processing the second plurality of correlated analog signals based on a set of dither signals, the quantization noise is independent from the second plurality of correlated analog signals.

In an exemplary implementation form of the ADC device, the analog-to-digital-converter is configured to process each of the second plurality of dithered amplified correlated analog signals based on an analog modulo operation followed by a sampling and quantization operation to provide a second plurality of quantization indices.

Lattice representation provides an alternative representation which is useful for the analysis and derivations.

In an exemplary implementation form of the ADC device, the analog-to-digital-converter is configured to process the second plurality of quantization indices based on a set of quantization codebooks and a reconstruction matrix, wherein the reconstruction matrix is based on the set of modulo-ADC parameters.

By processing the second plurality of quantization indices based on a set of quantization codebooks, available mathematical models can be used thereby reducing the complexity of the design.

In an exemplary implementation form of the ADC device, the analog-to-digital-converter is configured to process the second plurality of quantization indices based on a set of modulo lattice operations.

By such processing based on a set of modulo lattice operations, the correlation of the plurality of correlated analog signals can be exploited to improve the accuracy of the digital representation.

In an exemplary implementation form of the ADC device, the analog-to-digital-converter is configured to provide the digital representation of the second plurality of correlated analog signals based on a signal model of the first plurality of analog input signals, wherein the signal model is based on the set of modulo-ADC parameters, the set of analog mixing parameters and a quantization noise.

By using such a signal model, least squares approaches can be applied to iteratively invert the system.

In an exemplary implementation form of the ADC device, the signal model is a linear system specified as: $\mathbf{r}[\ell] \approx \mathbf{A} (\mathbf{Gy}[\ell] - \mathbf{z}[\ell]) = \mathbf{AG}\Phi_{(M)}\mathbf{x}[\ell] - \mathbf{Az}[\ell]$, where $\mathbf{x}[\ell]$ denotes the first plurality of analog input signals, $\mathbf{y}[\ell]$ denotes the second plurality of correlated analog signals, $\mathbf{r}[\ell]$ denotes the digital representation of the second plurality of correlated analog signals, $\mathbf{z}[\ell]$ denotes the quantization noise, $\Phi_{(M)}$ denotes a mixing matrix, $\mathbf{A}$ denotes a reconstruction matrix and $\mathbf{G}$ denotes a diagonal matrix containing the amplifier gains.

By using such a linear signal model, less complex mathematical methods such as the Moore-Penrose pseudo inverse can be applied to determine the inverse of the system.

In an exemplary implementation form of the ADC device, the digital estimator is configured to provide the digital representation of the first plurality of analog input signals based on an inversion of the signal model of the first plurality of analog input signals provided by the analog-to-digital-converter.

By applying such inversion, the originally transmitted signal can be efficiently reconstructed and thus, accuracy of the ADC device can be improved.

In an exemplary implementation form of the ADC device, the inversion of the signal model is based on a minimum mean square error criterion using knowledge about statistics of the first plurality of analog input signals and statistics of the quantization noise.

This provides the advantage that standard algorithms for minimum mean square error estimation can be efficiently applied.

In an exemplary implementation form of the ADC device, the matrix of amplifier gains and the reconstruction matrix are based on the set of analog mixing parameters.

This provides the technical advantage that feedback of the analog mixing parameters can be applied to improve the accuracy of digital representation.

In an exemplary implementation form of the ADC device, the matrix of amplifier gains and the reconstruction matrix are based on a covariance matrix of the first plurality of analog input signals.

This provides the technical advantage that information about a correlation of the analog input signals can be used to improve the accuracy of AD conversion.

According to a second aspect, the disclosure relates to a method for analog-to-digital conversion, the method comprising: computing linear combinations of a first plurality of analog input signals based on a set of analog mixing parameters to provide a second plurality of correlated analog signals; converting the second plurality of correlated analog signals to a digital representation of the second plurality of correlated analog signals based on a set of modulo-ADC parameters; converting the digital representation of the second plurality of correlated analog signals to a digital representation of the first plurality of analog input signals based on the set of analog mixing parameters and the set of modulo-ADC parameters; wherein the set of modulo-ADC parameters is based on a correlation of the second plurality of correlated analog signals.

Such an ADC method can be used for wideband AD conversion with very high resolution and can be applied for wideband multi-GHz analog signals. Such AD conversion method obtains accuracy gains, as shown in

Figures 12a and 12b, coming from a particular combination of blocks and not only from increasing the number of individual ADCs. The performance of the AD conversion is robust to the exact correlation of the analog inputs and does not require to estimate it.

In an exemplary implementation form of the method, the second plurality of correlated analog signals is larger than the first plurality of analog input signals.

In an exemplary implementation form of the method, the set of modulo-ADC parameters is based on a deviation of the digital representation of the first plurality of analog input signals from the first plurality of analog input signals.

In an exemplary implementation form of the method, the method comprises: providing the digital representation of the second plurality of correlated analog signals based on a signal model of the first plurality of analog input signals, wherein the signal model is based on the set of modulo-ADC parameters, the set of analog mixing parameters and a quantization noise.

In an exemplary implementation form of the method, the signal model is a linear system specified as: $\mathbf{r}[\ell] \approx \mathbf{A}(\mathbf{G}\mathbf{y}[\ell] - \mathbf{z}[\ell]) = \mathbf{AG}\Phi_{(M)}\mathbf{x}[\ell] - \mathbf{Az}[\ell]$, where $\mathbf{x}[\ell]$ denotes the first plurality of analog input signals, $\mathbf{y}[\ell]$ denotes the second plurality of correlated analog signals, $\mathbf{r}[\ell]$ denotes the digital representation of the second plurality of correlated analog signals, $\mathbf{z}[\ell]$ denotes the quantization noise, $\Phi_{(M)}$ denotes a mixing matrix, $\mathbf{A}$ denotes a reconstruction matrix and G denotes a diagonal matrix of amplifier gains.

In an exemplary implementation form of the method, the method comprises: providing the digital representation of the first plurality of analog input signals based on an inversion of the signal model of the first plurality of analog input signals.

In an exemplary implementation form of the method, the inversion of the signal model is based on a minimum mean square error criterion using knowledge about statistics of the first plurality of analog input signals and statistics of the quantization noise.

In an exemplary implementation form of the method, the matrix of amplifier gains and the reconstruction matrix are based on the set of analog mixing parameters.

In an exemplary implementation form of the method, the matrix of amplifier gains and the reconstruction matrix are based on a covariance matrix of the first plurality of analog input signals.

According to a third aspect, the disclosure relates to a computer program product comprising program code to perform the method according to the second aspect as described above, when executed by a computer.

According to a fourth aspect, the disclosure relates to a non-transitory computer readable medium having stored thereon instructions, wherein the instructions, when executed by a processor in an electronic device, cause the processor to perform operations of any of the implementation forms of the method described above.

BRIEF DESCRIPTION OF THE DRAWINGS

Further embodiments of the invention will be described with respect to the following figures, in which:

Fig. 1 shows a schematic diagram of a digital signal processing system 100;

Fig. 2 shows a schematic diagram of an exemplary implementation 200 of the digital signal processing system 100 of Figure 1;

Fig. 3 shows a schematic diagram of a modulo-ADC architecture 300 for analog-to-digital conversion;

Fig. 4 shows a schematic diagram illustrating an analog-to-digital converter (ADC) device 400 according to the disclosure;

Fig. 5 shows a schematic diagram illustrating an exemplary implementation of the modulo-ADC unit 500 of the ADC device 400 depicted in Figure 4;

Fig. 6 shows a schematic diagram illustrating an exemplary implementation of the analog blocks 600 of the modulo-ADC unit 500 depicted in Figure 5;

Fig. 7 shows a schematic diagram illustrating an exemplary characteristic of the analog modulo 603 depicted in Figure 6;

Fig. 8 shows a schematic diagram illustrating an exemplary implementation of the digital joint reconstruction unit 800 of the ADC device 400 depicted in Figure 4;

Fig. 9 shows a schematic diagram illustrating an exemplary procedure 900 performed by the digital control block 480 of the ADC device 400 depicted in Figure 4;

Fig. 10 shows a schematic diagram illustrating a general representation of an analog-to-digital converter (ADC) device 1000 according to the disclosure;

Fig. 11 shows a schematic diagram illustrating a method for analog-to-digital conversion 1100 according to the disclosure;

Fig. 12a shows an exemplary performance diagram of an ADC device according to the disclosure for uncorrelated input signals; and

Fig. 12b shows an exemplary performance diagram of an ADC device according to the disclosure for correlated input signals.

DETAILED DESCRIPTION OF EMBODIMENTS

In the following detailed description, reference is made to the accompanying drawings, which form a part thereof, and in which is shown by way of illustration specific aspects in which the disclosure may be practiced. It is understood that other aspects may be utilized and structural or logical changes may be made without departing from the scope of the present disclosure. The following detailed description, therefore, is not to be taken in a limiting sense, and the scope of the present disclosure is defined by the appended claims.

It is understood that comments made in connection with a described method may also hold true for a corresponding device or system configured to perform the method and vice versa. For example, if a specific method step is described, a corresponding device may include a unit to perform the described method step, even if such unit is not explicitly described or illustrated in the figures. Further, it is understood that the features of the various exemplary aspects described herein may be combined with each other, unless specifically noted otherwise.

The described devices may include integrated circuits and may be manufactured according to various technologies. For example, the circuits may be designed as logic integrated circuits, analog integrated circuits, mixed signal integrated circuits, optical circuits, memory circuits and/or integrated passives.

The devices, methods and systems described herein may include processors. In the following description, the term "processor" describes any device that can be utilized for processing specific tasks (or blocks or steps). A processor can be a single processor or a multi-core processor or can include a set of processors or can include means for processing. A processor can process software or firmware or applications etc.

The disclosed ADC architecture comprises a novel ADC unit configured to transform a plurality of analog input signals into a plurality of digital signals that are further processed at the DSP unit. A novel ADC architecture is provided which is able to create and exploit correlation among the analog signals to be converted by including:

(i) an analog mixing block at the ADC unit, which combines the analog inputs signals to create a (larger) number of correlated analog signals;
(ii) a modulo-ADC unit and the corresponding digital joint reconstruction block;
(iii) additional digital signal processing functions to jointly obtain a digital reconstruction of the received signals at the DSP unit; and
(iv) a digital control block to adapt the behavior of blocks (ii) and (iii) to the correlation created by block (i).

This way, the effective resolution is improved with respect to conventional ADCs using the same quantization resolution. Indeed, the combination of (i), (ii), and (iii), when the corresponding parameters are properly selected by (iv), happens to minimize the effects of the quantization noise in the digital reconstructed signals as opposed to conventional ADC units, which are ultimately limited by the resolution of the individual quantizers.

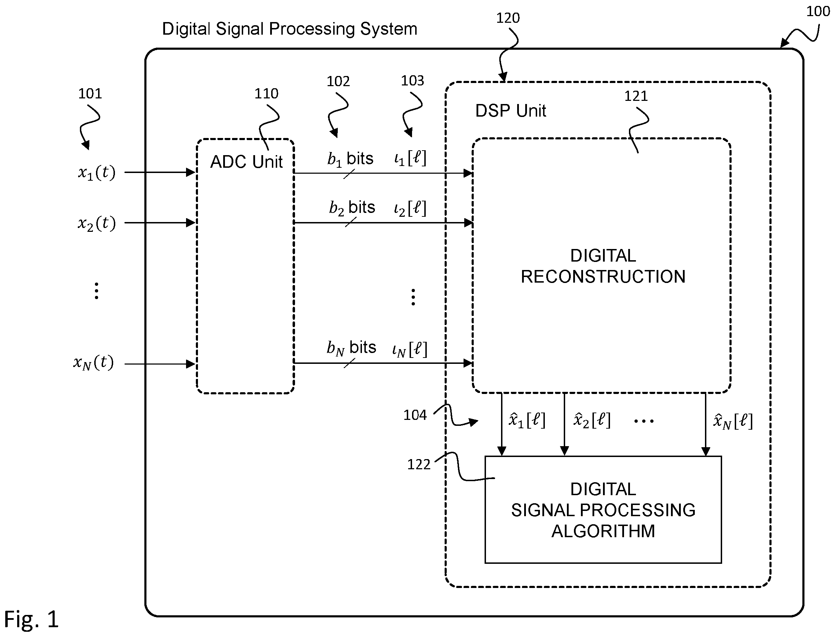

Fig. 1 shows a schematic diagram of a digital signal processing system 100. The digital signal processing system 100 comprises an analog-to-digital (ADC) unit 110 for receiving a number of $N$ analog signals 101 and converting these $N$ analog signals 101 to a number of $N$ digital signals 102. Each of the $N$ digital signals 102 is composed of $b_1$ to $b_N$ bits, respectively, and represents a corresponding index 103. The digital signal processing system 100 further comprises a digital signal processing (DSP) unit 120 including a digital reconstruction circuitry 121 and a digital signal processing algorithm 122. The digital reconstruction circuitry 121 processes the $N$ digital signals 102 to provide a digital representation 104 of the input signal 101. This digital representation 104 of the input signal 101 can be further processed by the digital signal processing algorithm 122.

Hence, in the digital signal processing system 100, the $N$ analog inputs 101 are converted to $N$ digital signals 102 by the ADC unit 110 so that the $N$ analog signals 101 can be digitally reconstructed 104 and further processed with some digital signal processing algorithm 122 in the DSP unit 120.

Applying digital signal processing algorithms to a plurality of analog input signals 101 requires an interface between the analog signals 101 and the digital signal processor 120. As shown in Figure 1, the analog signals 101 are sampled and quantized using the analog-to-digital conversion (ADC) unit 110 to create the digital inputs 102 required by any digital signal processing unit 120. If the analog input signals 101 are sampled at Nyquist rate or above and quantized with very high precision, then the effects of the ADC unit 110 are negligible, since the digital signals 104 reconstructed at the digital signal processing (DSP) unit 120 from the ADC outputs 102 approximate the analog input signals 101 with negligible distortion.

The disclosure provides a technique for, given some bit-resolutions in the ADC unit 110, minimizing some loss function $F_0(D_1, \dots, D_N)$ of the individual distortions $D_n$, which provide a measure of the error incurred when digitally representing the analog inputs signals 101, $x_1(t), \dots, x_N(t)$ by their digital representation 104, $\hat{x}_1[\ell], \dots, \hat{x}_N[\ell]$. Alternatively, a technique is provided for, given some target loss function $F_0(D_1, \dots, D_N)$ of the individual distortions $D_n$, lower the bit-resolutions required by the individual ADCs in the ADC unit 110.

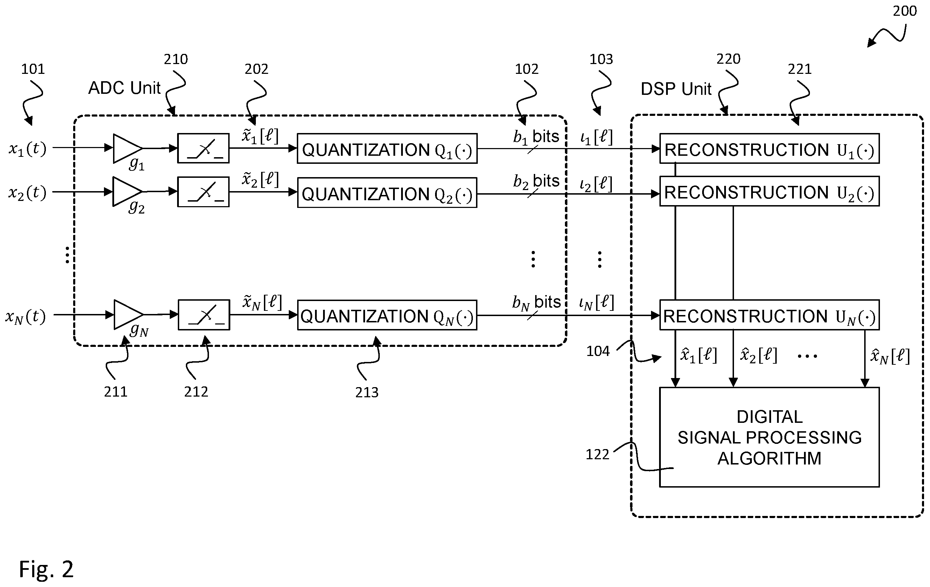

Fig. 2 shows a schematic diagram of an exemplary implementation 200 of the digital signal processing system 100 of Figure 1. In the digital signal processing system 200 shown in Figure 2, the ADC unit 210 comprises for each of the $N$ paths processing the $N$ analog signals 101 a gain unit 211, a sampling unit 212 and a quantization unit 213. The $N$ digital signals 102 or their corresponding indices 103, respectively, are output by the ADC unit 210. The DSP unit 220 comprises $N$ reconstruction units 221 to produce the digital representation 104 of the input signal 101 which may be further processed by the digital signal processing algorithm 122.

In the ADC unit 210, each analog input 101 is independently quantized based on its marginal statistics using, e.g., a uniform symmetric quantizer 213 with some given bit-resolution and uniform quantization thresholds adapted to the statistics of the analog input 101. Then, each analog input 101 is digitally reconstructed 104 uniquely based on the output bits 102 of the corresponding quantizer 213. As this specific architecture processes independently all analog inputs 101, its ultimate performance is dictated by the individual ADCs of the ADC unit 210 which with current technology fail to deliver the accuracy required in envisioned THz wireless communication.

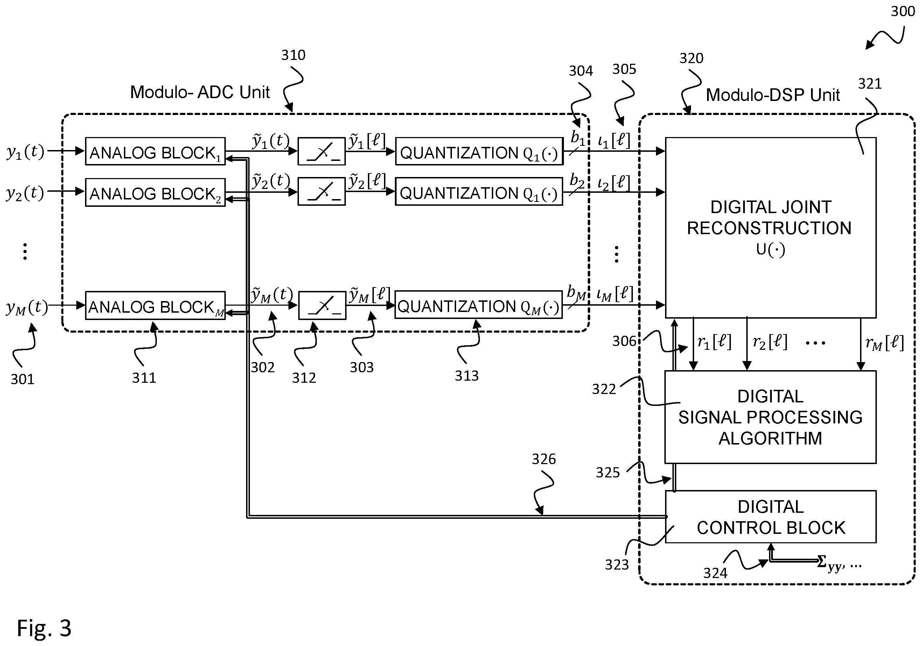

Fig. 3 shows a schematic diagram of a modulo-ADC architecture 300 for analog-to-digital conversion. In the modulo-ADC architecture 300 shown in Figure 3, the modulo-ADC Unit 310 comprises for each of the $M$ paths processing the $M$ analog signals 301 an analog block 311 providing a respective analog output signal 302 which is further processed by a sampling unit 312 and a quantization unit 313. The M digital signals 304 or their corresponding indices 305, respectively, are output by the modulo-ADC unit 310. The Modulo-DSP unit 320 comprises a digital joint reconstruction unit 321 to produce the digital representation 306 of the input signal 301 which may be further processed by the digital signal processing algorithm 322. A digital control block 323 is used to control the analog blocks 311 of each of the M paths. The digital control block 323 further controls the digital joint reconstruction unit 321 and the digital signal processing algorithm 322.

The accuracy of converting multiple analog signals to multiple digital signals can be substantially increased by exploiting any correlation that may exist among them. The ADC depicted in Figure 3 will be referred to as modulo-ADC architecture 300. The analog input signals 301 correspond to the analog received signals by a multi-antenna digital receiver. Hence, these signals can be assumed to be correlated as a result of going through the wireless propagation channel. This fact can be exploited to achieve a higher "effective" accuracy than the nominal accuracies of the individual ADCs used in the modulo-ADC architecture.

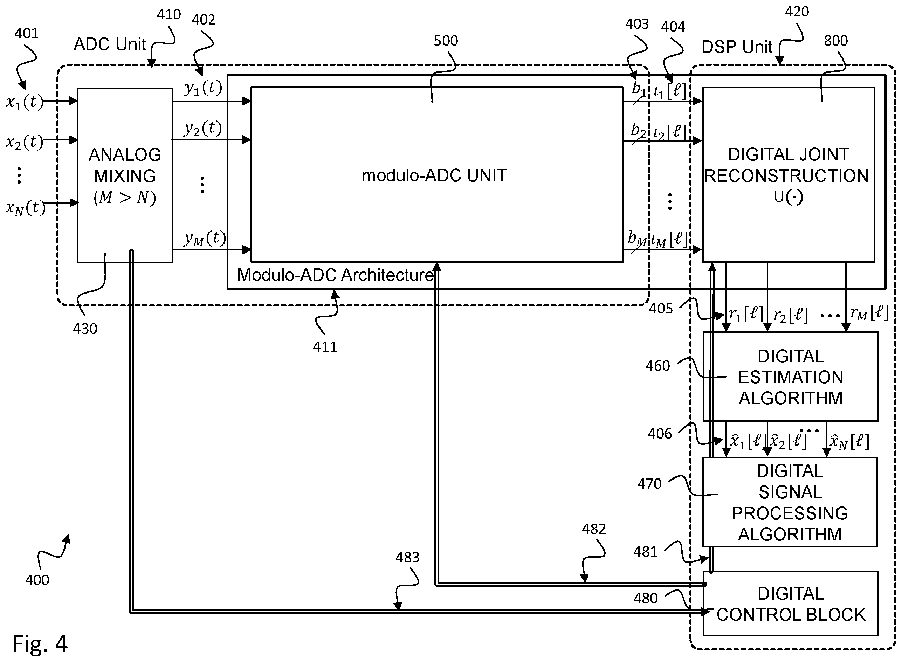

As the present disclosure is directed to a general digital signal processing system and no correlation can be assumed between the analog input signals 101 as shown in Figure 1, the modulo-ADC architecture 300 of Figure 3 is modified to be used for the problem at hand. Thus, a novel analog-to-digital converter (ADC) device is introduced as will be described below with respect to Figures 4 to 10.

Fig. 4 shows a schematic diagram illustrating an analog-to-digital converter (ADC) device 400 according to the disclosure.

The ADC device 400 is partitioned in an ADC unit 410 and a DSP unit 420, comprising:

(i) an analog mixing block 430 (at the ADC unit 410) with $N$ analog inputs 401 and $M \geq N$ analog outputs 402;
(ii) a modulo-ADC block (or modulo-ADC architecture) 411 including a modulo-ADC unit 500 (at the ADC unit 410) with $M$ analog inputs 402 and the corresponding digital joint reconstruction block 800 (at the DSP unit 420) delivering M digital outputs 405;
(iii) a digital estimation block (or digital estimation algorithm) 460 (at the DSP unit 420) with $M$ digital inputs 405 and $N$ digital outputs 406;

(iv) and, a digital control block 480 (at the DSP unit 420), which delivers the control signals 481, 482, 483 to adapt the behavior of the previous blocks.

At the DSP unit 420, a digital signal processing algorithm 470 is also implemented. The analog mixing block 430 may also be referred to as analog mixer, analog mixing circuit, analog mixing circuitry or analog mixing processing circuitry. The modulo-ADC block 411 may also be referred to as modulo-ADC, modulo-ADC circuit, modulo-ADC circuitry or modulo-ADC processing circuitry. The digital estimation block 460 may also be referred to as digital estimator, digital estimation circuit, digital estimation circuitry or digital estimation processing circuitry. The digital control block 480 may also be referred to as digital controller, digital control circuit, digital control circuitry or digital control processing circuitry.

These functional blocks 430, 411, 500, 800, 460, 480 do not have to be collocated in space or part of a unique physical device but can also be implemented in different physical devices jointly acting as a unique digital signal processing system. Descriptions and possible embodiments of the previous blocks are provided in the following.

The analog mixing block 430 receives as inputs: $N$ analog input signals 401: $x_n(t)$, for $n = 1,2, ... , N$. The Analog Mixing Block 430 outputs: $M$ analog correlated signals 402: $y_m(t)$, for $m = 1,2, ... , M$.

One purpose of the analog mixing block 430 is to create $M \geq N$ (usually, $M \gg N$) correlated analog signals 402 out of the $N$ analog input signals 401 to be digitally converted. Although the behavior of this block 430 can be adapted by the digital control block 480, it is preferable to keep it fixed to reduce the adaptation rate of the subsequent blocks.

In an embodiment, the analog mixing block 430 can be implemented, for instance, by computing M linear combinations of the $N$ analog inputs 401 using a mixing matrix $\Phi_{(M)} = [\phi_1, ... , \phi_M]^{\mathrm{T}} \in \mathbb{R}^{M \times N}$ :

$$y_m(t) = \phi_m^{\mathrm{T}} x(t) = \phi_m^{\mathrm{T}}[\, x_1(t) \quad x_2(t) \quad \cdots \quad x_N(t)]^{\mathrm{T}}, \qquad m = 1,2, ... , M. \qquad (1)$$

Gathering all M outputs 402 in vector $y(t) = [y_1(t), ... , y_M(t)]^T$, one can equivalently write

$$y(t) = \Phi_{(M)} x(t). \qquad (2)$$

In this case, the correlation matrix of the output signals 402 is given by

$$\Sigma_{yy} = E\{y(t)y(t)^{\mathrm{T}}\} = \Phi_{(M)}E\{x(t)x(t)^{\mathrm{T}}\}\Phi_{(M)}^{\mathrm{T}} = \Phi_{(M)}\Sigma_{xx}\Phi_{(M)}^{\mathrm{T}}. \qquad (3)$$

The modulo-ADC block 411 receives as inputs: analog correlated signal 402, $y_{(t)} = [y_1(t), ... , y_M(t)]^T$ and analog/digital control signal 482 provided by the digital control block 480 (e.g. amplifier gains G and reconstruction matrix A).

The modulo-ADC block 411 outputs the digital reconstruction vector 405, $r[\ell] = [r_1[\ell], ... , r_M[\ell]]^T$.

The modulo-ADC block 411 may correspond to the modulo-ADC architecture 300 described above with respect to Figure 3.

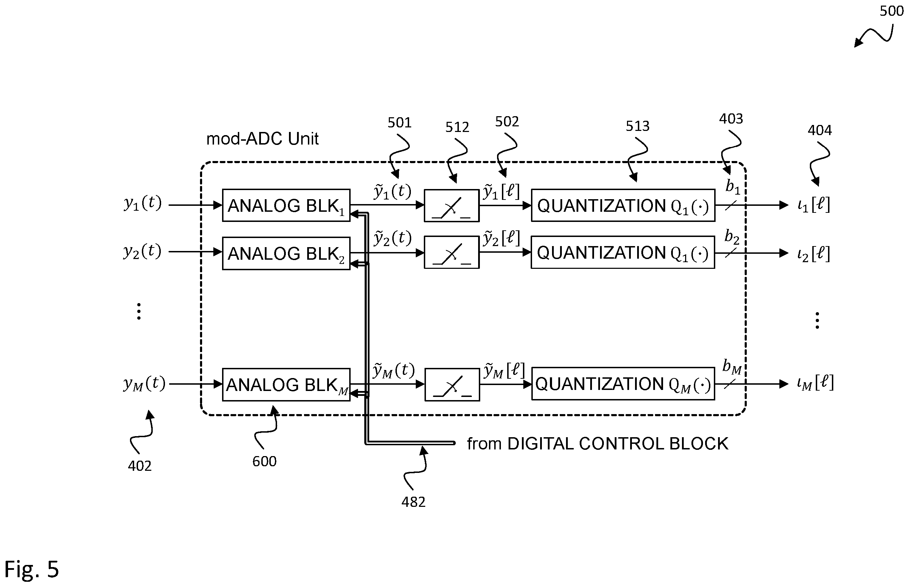

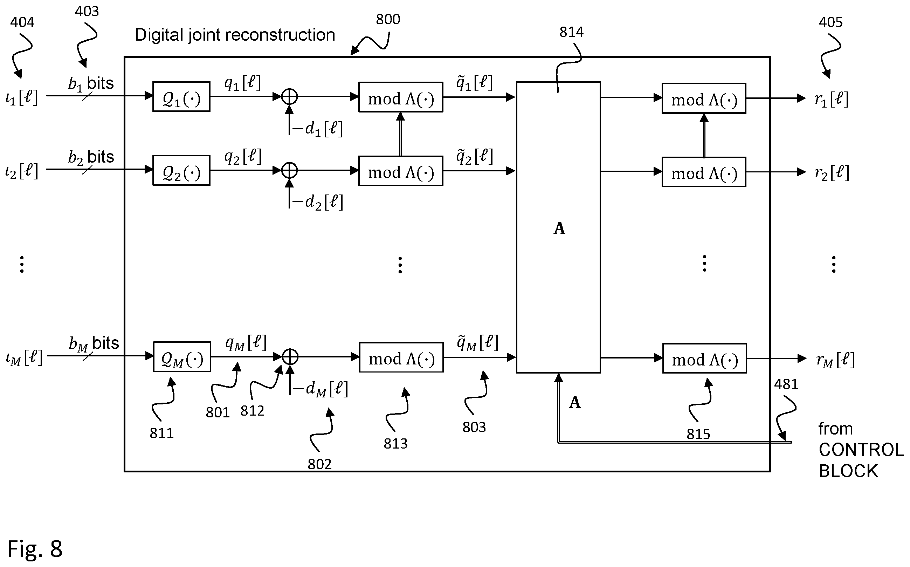

The modulo-ADC block 411 includes a modulo-ADC unit 500 (at the ADC unit 410) that is described below with respect to Figure 5. The modulo-ADC block 411 further includes the corresponding digital joint reconstruction block (or digital joint reconstruction unit) 800 that is described below with respect to Figure 8.

In the digital joint reconstruction unit 800, all M quantization codewords $q[\ell] = [q_1[\ell], ... , q_M[\ell]]^{\mathrm{T}} \in \mathbb{R}^{M \times 1}$ provided by the modulo-ADC unit 500, as described below with respect to Figure 5, are jointly processed at the DSP unit 420 to obtain a reconstruction vector 405, $r[\ell] = [r_1[\ell], ... , r_M[\ell]]^{\mathrm{T}} \in \mathbb{R}^{M \times 1}$ as described below with respect to Figure 8.

The digital estimation algorithm 460, also referred to as digital joint estimation block 460, receives as inputs the digital reconstruction vector 405, $r[\ell] = [r_1[\ell], ... , r_M[\ell]]^T$ from the modulo-ADC block 411, the analog mixing parameters 481 (e.g., mixing matrix $\Phi_{(M)}$) and the modulo-ADC parameters 481 (amplifier gains G and reconstruction matrix **A**) from the digital control block 480.

The digital estimation algorithm 460 outputs the joint digital reconstructed signal 406, $\hat{x}[\ell]$.

The digital joint estimation block 460 is configured to jointly process all $M$ entries of the digital reconstruction vector 405, $r[\ell]$, so that the output 406, $\hat{x}[\ell] = [\hat{x}_1[\ell], ... , \hat{x}_N[\ell]]^T$ provides a digital representation 406 of the $N$ analog input signals 401, $x(t) = [x_1(t), ... , x_M(t)]^T$. Given the analog mixing parameters (e.g., mixing matrix $\Phi_{(M)}$) and the modulo-ADC parameters (amplifier gains **G** and reconstruction matrix **A**), this estimation block 460 is designed by minimizing some loss function $F_0(D_1, ... , D_N)$ of the individual distortions $D_n$. The particular processing in this block 460 depends on the particular embodiments adopted in the previous blocks.

An exemplary implementation of the digital joint estimation block 460 is described in the following.

Assuming that the analog mixing block 430 is implemented according to the implementation as described above, then, it holds that

$$y(t) = \Phi_{(M)}x(t). \qquad (12)$$

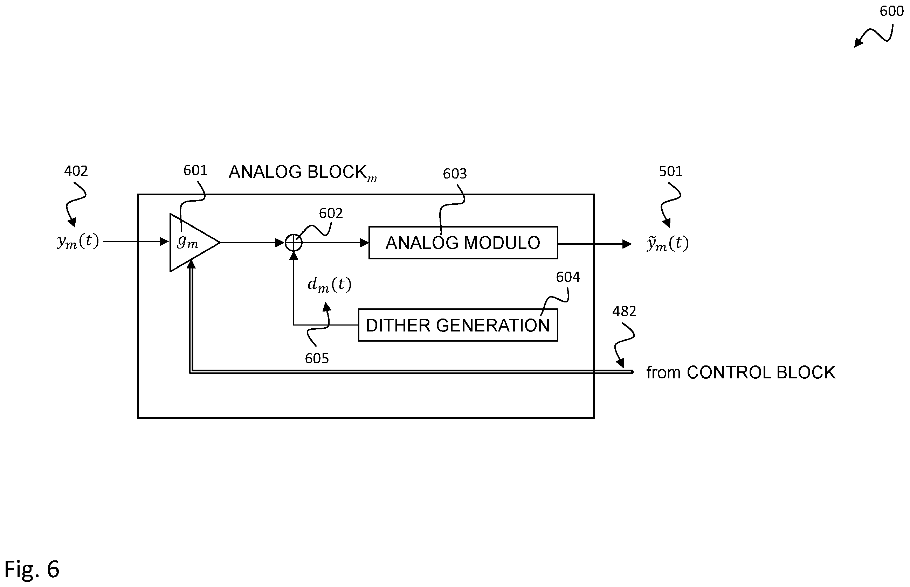

Further assuming that the modulo-ADC block 411 is implemented according to the implementation as described above, that is, the modulo-ADC unit 500 comprises M analog processing blocks 600 implemented according to the embodiment described below with respect to Figures 5 and 6 and M uniform symmetric mid-rise quantizers 513 according to the embodiment described below with respect to Figure 5, and that the corresponding digital joint reconstruction block 800 is implemented according to the embodiment described below with respect to Figure 8. Then, the combination of the previous embodiments can be approximately modeled as

$$r[\ell] \approx A(Gy[\ell] - z[\ell]) = AG\Phi_{(M)}x[\ell] - Az[\ell] \qquad (13)$$

where $z[\ell] = [z_1[\ell], \dots, z_M[\ell]]^{\mathrm{T}} \in \mathbb{R}^{M \times 1}$ denotes the quantization noise uniformly distributed in $[-(\alpha/2)2^{-bm}, (\alpha/2)2^{-bm})$ and uncorrelated with signal of interest $\mathbf{x}[\ell]$. Given the signal model in equation (13), one can apply any estimation algorithm which estimates $\hat{\mathbf{x}}[\ell]$ from the reconstruction vector $r[\ell]$. The particular choice depends on how much is known or assumed from $\mathbf{x}[\ell]$.

In one exemplary implementation, a least squares approach can be adopted and the linear system in (13) can be simply inverted by using the Moore-Penrose pseudo inverse:

$$\hat{x}[\ell] = \left( \left( AG\Phi_{(M)} \right)^{\mathrm{T}} \left( AG\Phi_{(M)} \right) \right)^{-1} \left( AG\Phi_{(M)} \right)^{\mathrm{T}} r[\ell]. \qquad (14)$$

It may be possible to exploit the knowledge of the statistics of $\hat{\mathbf{x}}[\ell]$ and statistics of the quantization noise $\mathbf{z}[\ell]$ to minimize the loss function $F_0(D_1, \dots, D_N)$ of the individual distortions $D_n$. Assuming, for instance that the distortion $D_n$ is measured by the reconstruction mean squared error (MSE):

$$D_n = E\{|x_n[\ell] - \hat{x}_n[\ell]|^2\} \qquad (15)$$

Then, the linear estimator minimizing the distortions $D_n$ in (15) for $n = 1,2, \dots, N$ under the model in (13) is given by

$$\hat{x}[\ell] = \left( AG\Phi_{(M)}\Sigma_{xx} \right)^{\mathrm{T}} \left( (AG\Phi_{(M)})\Sigma_{xx} \left( AG\Phi_{(M)} \right)^{\mathrm{T}} + (\alpha^2/12)AD_bA^{\mathrm{T}} \right)^{-1} r[\ell] \qquad (16)$$

where the input correlation matrix $\Sigma_{xx} = E\{\mathbf{x}(t)\mathbf{x}(t)^{\mathrm{T}}\}$ is introduced and it holds that quantization noise satisfies $E\{\mathbf{z}[\ell]\mathbf{z}[\ell]^{\mathrm{T}}\} = \alpha^2/12 \, D_b$ (see above).

It may be possible to be more accurate on the mathematical model for the reconstruction vector $r[\ell]$, by applying equation (7). Taking this fact into account the following can be obtained

$$r_m[\ell] = \begin{cases} \mathbf{a}_m^{\mathrm{T}}(\mathbf{G}y[\ell] - z[\ell]) & \text{with probability } \Pr(\mathbf{G}, \mathbf{a}_m) = \Pr(|\mathbf{a}_m^{\mathrm{T}}(\mathbf{G}y[\ell] - z[\ell])| \leq \alpha/2) \\ \tau_m[\ell] & \text{with probability } 1 - \Pr(\mathbf{G}, \mathbf{a}_m) \end{cases} \qquad (17)$$

where $\tau_m[\ell]$ behaves as a random signal uniformly distributed in $[-\alpha/2, \alpha/2)$. Then, a linear estimator minimizing the distortions $D_n$ in (15) for $n = 1,2, \dots, N$ under the model in (17) is given by

$$\hat{x}[\ell] = \Sigma_{rx}^{\mathrm{T}}\Sigma_{rr}^{-1}r[\ell] \qquad (18)$$

where $\Sigma_{rr} = E\{r[\ell]r[\ell]^{\mathrm{T}}\} \in \mathbb{R}^{M \times M}$ and $\Sigma_{rx} = E\{r[\ell]x[\ell]^{\mathrm{T}}\} \in \mathbb{R}^{M \times N}$ are defined with entries given by

$$[\mathbf{\Sigma}_{rr}]_{i,i} = E\{r_i^2[\ell]\} \approx \mathbf{a}_i^{\mathrm{T}}\left(\left(\mathbf{G}\mathbf{\Phi}_{(M)}\right)\mathbf{\Sigma}_{xx}\left(\mathbf{G}\mathbf{\Phi}_{(M)}\right)^{\mathrm{T}} + \frac{\alpha^2}{12}\mathbf{D}_b\right)\mathbf{a}_i \Pr(\mathbf{G},\mathbf{a}_i) + \frac{\alpha^2}{12}\left(1 - \Pr(\mathbf{G},\mathbf{a}_i)\right)$$

$$[\mathbf{\Sigma}_{rr}]_{i,j} = E\{r_i[\ell]r_j[\ell]\} \approx \mathbf{a}_i^{\mathrm{T}}\left(\left(\mathbf{G}\mathbf{\Phi}_{(M)}\right)\mathbf{\Sigma}_{xx}\left(\mathbf{G}\mathbf{\Phi}_{(M)}\right)^{\mathrm{T}} + \frac{\alpha^2}{12}\mathbf{D}_b\right)\mathbf{a}_j \Pr(\mathbf{G},\mathbf{a}_i,\mathbf{a}_j), \; i \neq j \tag{19}$$

$$[\mathbf{\Sigma}_{rx}]_{i,j} = E\{\hat{y}_i[\ell]x_j[\ell]\} \approx \left(\mathbf{a}_i^{\mathrm{T}}\mathbf{G}\mathbf{\Phi}_{(M)}[\mathbf{\Sigma}_{xx}]_j\right)\Pr(\mathbf{G},\mathbf{a}_i)$$

where $\Pr(\mathbf{G},\mathbf{a}_i,\mathbf{a}_j) = \Pr(|\mathbf{a}_i^{\mathrm{T}}(\mathbf{G}\mathbf{y}[\ell] - \mathbf{z}[\ell])| \leq \alpha/2, |\mathbf{a}_j^{\mathrm{T}}(\mathbf{G}\mathbf{y}[\ell] - \mathbf{z}[\ell])| \leq \alpha/2)$ and $[\mathbf{\Sigma}_{xx}]_j$ denotes the $j$th column of $\Sigma_{xx}$.

The digital control block 480 receives as inputs 483 the analog mixing parameters (e.g., mixing matrix $\Phi_{(M)}$) and (optionally) the correlation matrix of signal 401, $x_n(t)$, $n = 1, \dots, N$, denoted by $\Sigma_{xx}$.

The digital control block 480 outputs the modulo-ADC parameters 481, 482 (amplifier gains **G** and reconstruction matrix **A**).

The functionality of the digital control block 480 is described in the following.

One purpose of the digital control block 480 is to adapt the behavior of the modulo-ADC block 411, that is, the M analog processing blocks 600 in the ADC unit 500 (see Figures 5 and 6), and the behavior of the digital joint reconstruction block 800 (see Figure 8) in the DSP unit 420, to the correlation introduced by the analog mixing block 430 and (possibly) to correlation of the analog inputs 401 (if there is any correlation between them). Since the final objective is to minimize some loss function $F_0(D_1, \dots, D_N)$ of the individual distortions $D_n$, the digital control block 480 obtains the modulo-ADC parameters 483 by solving the following optimization problem:

$$\{\mathbf{G},\mathbf{A}\} = \arg \max_{\mathbf{G}\in\mathcal{G},\; \mathbf{A}\in\mathcal{A}} \quad F_0\left(D_1(\mathbf{G},\mathbf{A}), \dots, D_N(\mathbf{G},\mathbf{A})\right) \tag{20}$$

where A denotes the reconstruction matrix 814 (see Figure 8) and $\mathcal{A}$ the corresponding feasible set, and **G** = diag($g_1, \dots, g_M$) contains the $M$ amplifier gains to be applied in the modulo-ADC unit 500 and $\mathcal{G}$ denotes the corresponding feasible set. The exact dependence of the individual distortions $D_n$ on the optimization variables **G** and **A** is essentially determined by the embodiments adopted in the analog mixing block 430, in the modulo-ADC block 411, and in the digital joint estimation block 460 and by the adopted distortion measure.

In an embodiment, it may be assumed that (i) the analog mixing block 430 follows the embodiment described above, (ii) the modulo-ADC block 411 follows the embodiment described above. Recall that the combination of the previous embodiments can be mathematically described as in equation (17), so that the mth entry of the reconstruction vector $r[\ell]$ only provides meaningful information with probability

$$\Pr(\mathbf{G},\mathbf{a}_m) = \Pr(|\mathbf{a}_m^{\mathrm{T}}(\mathbf{G}\mathbf{y}[\ell] - \mathbf{z}[\ell])| \leq \alpha/2). \tag{21}$$

In consequence, an approach for computing the reconstruction matrix A for some amplifier gains in G, results from simultaneously maximizing the probabilities in (21) for $m = 1, \dots, M$. Observing that

$$1 - \Pr\left(\max_m|\mathbf{a}_m^{\mathrm{T}}(\mathbf{G}\mathbf{y}[\ell] - \mathbf{z}[\ell])| > \frac{\alpha}{2}\right) \geq 1 - 2\sum_{m=1}^{M}\exp\left(-\frac{\alpha^2}{8\sigma^2(\mathbf{G},\mathbf{a}_m)}\right) \tag{22}$$

with

$$\sigma^2(\mathbf{G},\mathbf{a}_m) = \mathbf{a}_m^{\mathrm{T}}\left(\mathbf{G}^2\mathbf{\Phi}_{(M)}\mathbf{\Sigma}_{xx}\mathbf{\Phi}_{(M)}^{\mathrm{T}} + (\alpha^2/12)\mathbf{D}_b\right)\mathbf{a}_m \tag{23}$$

this can be approximately done by maximizing the lower bound in equation (22) as

$$\mathbf{A}^* = \arg \min_{\mathbf{A}\in\mathbb{Z}^{M\times M},\det(\mathbf{A})\neq 0} \max_m \sigma^2(\mathbf{G},\mathbf{a}_m)/\alpha^2$$
$$= \arg \min_{\mathbf{A}\in\mathbb{Z}^{M\times M},\det(\mathbf{A})\neq 0} \max_m \mathbf{a}_m^{\mathrm{T}}\left((\mathbf{G}^2/\alpha^2)\mathbf{\Phi}_{(M)}\mathbf{\Sigma}_{xx}\mathbf{\Phi}_{(M)}^{\mathrm{T}} + (1/12)\mathbf{D}_b\right)\mathbf{a}_m \tag{24}$$

where $\Sigma_{xx}$ can be set as $\Sigma_{xx}$ = diag($P_1, P_2, \dots, P_N$) with $P_n = E\{x_n^2(t)\}$ denoting the power of the nth analog input, whenever the input correlation matrix is not available. The optimization problem in (24) can be formulated as a lattice successive minima problem (SMP), which can be solved for instance using the algorithm described by J. Wen, L. Li, X. Tang, W. H. Mow and C. Tellambura: "An efficient optimal algorithm for integer-forcing linear MIMO receivers design," 2017 IEEE International Conference on Communications (ICC), Paris, 2017, pp. 1-6".

Then, given the reconstruction matrix **A**\* in equation (24), one can obtain the amplifier gains **G** = diag($g_1, \dots, g_M$) with $g_m > 0$ as

$$\mathbf{G}^* = \arg \min_{\mathrm{diag}(\mathbf{G})>0} \quad F_0\big(D_1(\mathbf{G}, \mathbf{A}^*), \dots, D_N(\mathbf{G}, \mathbf{A}^*)\big) \qquad\qquad (25)$$

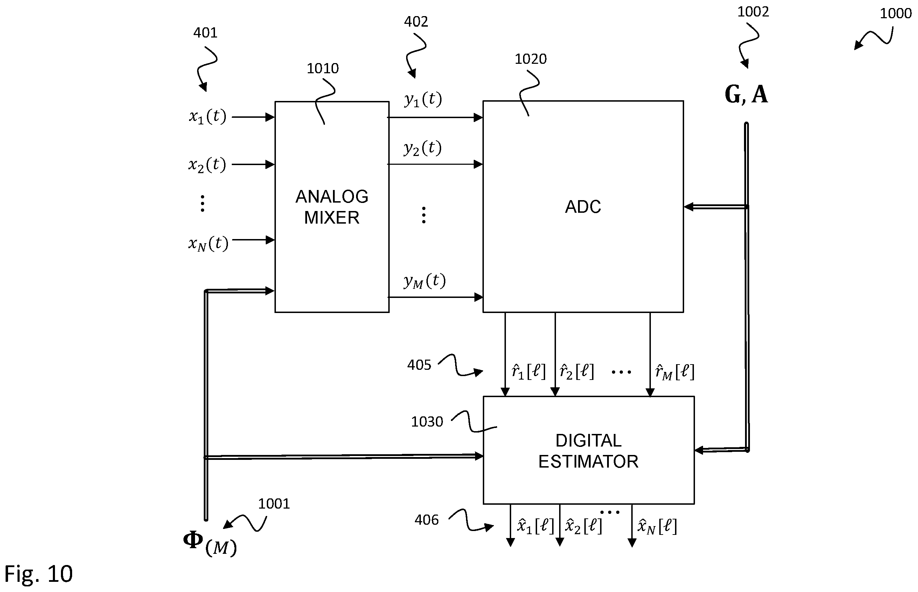

Finally, the output amplifier gains G and the reconstruction matrix A follow from iterating between solving the optimization problems in (24) and (25) as represented in Figure 10.

The outputs of this block only depend on the analog input signals through the correlation matrix $\Sigma_{xx}$. One can always set $\Sigma_{xx}$ = diag($P_1, P_2, \dots, P_N$), so that all the computations are performed offline and the parameters dictating the behavior of the disclosed ADC architecture 400 are not changed during operation. This way the computational complexity required at the DSP unit 420 by the disclosed ADC architecture is substantially reduced with respect to the modulo-ADC architecture 300 shown in Figure 3. Furthermore, the disclosed ADC architecture 400 can provide performance guarantees as opposed to the modulo-ADC architecture 300.

Fig. 5 shows a schematic diagram illustrating an exemplary implementation of the modulo-ADC unit 500 of the ADC device 400 depicted in Figure 4. The modulo-ADC unit 500 may correspond to the modulo-ADC unit 310 as described above with respect to Figure 3.

The modulo-ADC Unit 500 comprises for each of the M paths processing the *M* analog signals 402 an analog block 600 providing a respective analog output signal 501 which is further processed by a sampling unit 512 and a quantization unit 513. The analog block 600 is further described below with respect to Figure 6. The *M* digital signals 403 or their corresponding indices 404, respectively, are output by the modulo-ADC unit 500.

The functionality of the modulo-ADC unit 500 can be described as follows. First, each one of the analog input signals 402, $y_m(t)$ is independently processed by an analog processing block 600 to obtain signal 501, $\tilde{y}_m(t)$ and sampled by sampling unit 512 to generate the discrete-time signal 502, $\tilde{y}_m[\ell]$. The analog processing block 600 may be implemented as described below with respect to Figure 6.

The analog processing block 600 amplifies the input signal 402 with gain 601 (see Figure 6), $g_m$, adds a random dither signal 605, $d_m(t)$ that may be uniformly distributed in the range $2^{-bm}[-\alpha/2, \alpha/2]$, and applies the analog modulo operation 603 to $g_m y_m(t) + d_m(t)$, so that the resulting analog signal 501, $\tilde{y}_m(t) \in [-\alpha/2, \alpha/2]$ is given by

$$\tilde{y}_m(t) = \mathrm{mod}_\alpha\big(g_m y_m(t) + d_m(t)\big), \qquad m = 1, 2, \dots, M \qquad\qquad (4)$$

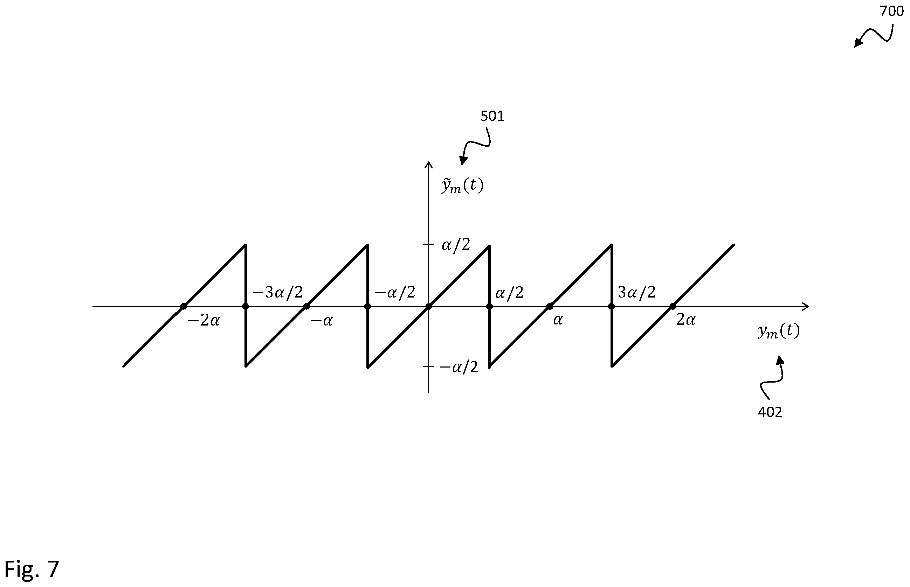

where $\mathrm{mod}_\alpha(\cdot)$ stands for the analog modulo operation as specified in Figure 7. The amplifier gain 601, $g_m$ is adapted based on some information 482 provided by the digital control block 480 as described above.

Then, the discrete-time version of signal 501, $\tilde{y}_m(t)$, denoted by signal 502, $\tilde{y}_m[\ell]$, is mapped sample-by-sample to a quantization index 404, $\iota_m[\ell] \in \{1, 2, \dots 2^{bm}\}$, corresponding to the codeword $q_m[\ell] = \mathcal{Q}_m(\iota_m[\ell])$ in the quantization

codebook $\mathcal{Q}_m$. Assuming that the m-th quantizer 513 following the m-th analog block 600 is a mid-rise uniform quantizer with a resolution of $b_m$ bits 403, input range $[-\alpha/2, \alpha/2]$, quantization step-size $\alpha_m = 2^{-bm}\alpha$, and reconstruction step-size $\beta_n = \alpha_m/2$. The effects of combining the analog processing blocks 600 with symmetric uniform quantizers 513 in the ADC unit can be better understood by resorting to one-dimensional lattices as described by R. Zamir in the document "Lattice Coding for Signals and Networks; United Kingdom: Cambridge. University Press, 2014". Considering M pairs of nested one-dimensional lattices $\Lambda \subseteq \Lambda_m$, with

$$\Lambda = \alpha \cdot \mathbb{Z}, \qquad \text{and} \qquad \Lambda_m = 2^{-b_m}\alpha \cdot \mathbb{Z}, \qquad m = 1, \dots, M \qquad\qquad (5)$$

forming the M quantization codebooks as $\mathcal{Q}_m = \Lambda_m \cap \mathcal{V}(\Lambda)$, for $m = 1, \dots, M$, where $\mathcal{V}(\Lambda) = [-\alpha/2, \alpha/2)$ denotes the Voronoi region of $\Lambda$. Then, the quantization codeword $qm[\ell] = \mathcal{Q}_m(\iota_m[\ell])$ corresponding to the m-th quantizer output $\iota_m[\ell]$ can be mathematically modeled as

$$q_m[\ell] = \left(Q_{\Lambda_m}\left((g_m y_m[\ell] + d_m[\ell] + \alpha_m/2) \bmod \Lambda\right) - \alpha_m/2\right) \bmod \Lambda \tag{6}$$

where $d_m[\ell]$ is the discrete-time version of the dither signal 605 corresponding to each quantization branch. The second equality follows from the commutative property of the lattice quantization with respect to $\Lambda_m$ and the modulo reduction with respect to $\Lambda$ operations for the one-dimensional lattices $\Lambda$ and $\Lambda_m$ in (5). Equation (6) uses the standard notation in the lattice coding literature as described, e.g. by R. Zamir in the document "Lattice Coding for Signals and Networks; United Kingdom: Cambridge. University Press, 2014".

Fig. 6 shows a schematic diagram illustrating an exemplary implementation of the analog blocks 600 of the modulo-ADC unit 500 depicted in Figure 5.

The analog processing block 600 amplifies the input signal 402 with gain 601, $g_m$, adds a random dither signal 605, $d_m(t)$ uniformly distributed in the range $2^{-bm}[-\alpha/2,\alpha/2]$, and applies the analog modulo operation 603 to $g_m y_m(t) + d_m(t)$, so that the resulting analog signal 501, $\tilde{y}_m(t) \in [-\alpha/2,\alpha/2]$ is given by

$$\tilde{y}_m(t) = \text{mod}_\alpha\left(g_m y_m(t) + d_m(t)\right), \qquad m = 1,2,\dots,M \tag{4}$$

where $\text{mod}_\alpha(\cdot)$ stands for the analog modulo operation as specified in Figure 7. The amplifier gain 601, $g_m$ is adapted based on some information 482 provided by the digital control block 480 described above with respect to Figure 4.

Fig. 7 shows a schematic diagram illustrating an exemplary characteristic of the analog modulo 603 depicted in Figure 6. The characteristic may be a periodical ramp as shown in Figure 7 with the period of $\alpha$. In the interval $[-\alpha/2,\alpha/2]$ the relation holds: $\tilde{y}_m(t) = y_m(t)$; in the interval $[\alpha/2,3\alpha/2]$ the relation holds: $\tilde{y}_m(t) = y_m(t) - \alpha$; in the interval $[3\alpha/2,5\alpha/2]$ the relation holds: $\tilde{y}_m(t) = y_m(t) - 2\alpha$; etc.

Fig. 8 shows a schematic diagram illustrating an exemplary implementation of the digital joint reconstruction unit 800 of the ADC device 400 depicted in Figure 4.

In the digital joint reconstruction unit 800, all M quantization codewords $q[\ell] = [q_1[\ell],\dots,q_M[\ell]]^T \in \mathbb{R}^{M\times 1}$ provided by the modulo-ADC unit 500 (see Figure 5) are jointly processed at the DSP unit 420 to obtain a reconstruction vector 405, $r[\ell] = [r_1[\ell],\dots,r_M[\ell]]^T \in \mathbb{R}^{M\times 1}$ as follows. Given the $M \times M$ reconstruction matrix 814, $\mathbf{A} = [\mathbf{a}_1,\dots,\mathbf{a}_M]^T \in \mathbb{Z}^{M\times M}$ with integer coefficients and non-zero determinant so that A is invertible provided by the digital control block 480 described above with respect to Figure 4, the reconstruction vector $r[\ell] = [r_1[\ell],\dots,r_M[\ell]]^T \in \mathbb{R}^{M\times 1}$ can be computed as

$$r_m[\ell] = \left(\mathbf{a}_m^T\left((q[\ell] - d[\ell]) \bmod \Lambda\right)\right) \bmod \Lambda, \qquad m = 1,\dots,M \tag{7}$$

where $d[\ell] = [d_1[\ell],\dots,d_M[\ell]]^T \in \mathbb{R}^{M\times 1}$. Applying standard properties of operations with lattices according to R. Zamir: "Lattice Coding for Signals and Networks; United Kingdom: Cambridge. University Press, 2014", equation (7) can be rewritten as

$$r_m[\ell] = \left(\mathbf{a}_m^T(\mathbf{G}y[\ell] - z[\ell])\right) \bmod \Lambda, \qquad m = 1,\dots,M. \tag{8}$$

where $\mathbf{G} = \text{diag}(g_1,\dots,g_M) \in \mathbb{R}^{M\times M}$, $y[\ell] = [y_1[\ell],\dots,y_M[\ell]]^T$, and $z[\ell] = [z_1[\ell],\dots,z_M[\ell]]^T \in \mathbb{R}^{M\times 1}$ denotes the quantization error with $z_m[\ell]$ uniformly distributed in $\mathcal{V}(\Lambda_m) = [-\alpha_m/2,\alpha_m/2]$. Observe now that, whenever

$$|\mathbf{a}_m^T(\mathbf{G}y[\ell] - z[\ell])| \leq \alpha/2, \qquad m = 1,\dots,M \tag{10}$$

it holds that

$$r_m[\ell] = \mathbf{a}_m^T(\mathbf{G}y[\ell] - z[\ell]), \qquad m = 1,\dots,M \tag{11}$$

and, hence, each entry $r_m[\ell]$ is the digital reconstruction of a linearly independent linear combination of the correlated analog signals in $y(t)$ with coefficients given by the rows of the reconstruction matrix A plus some quantization noise.

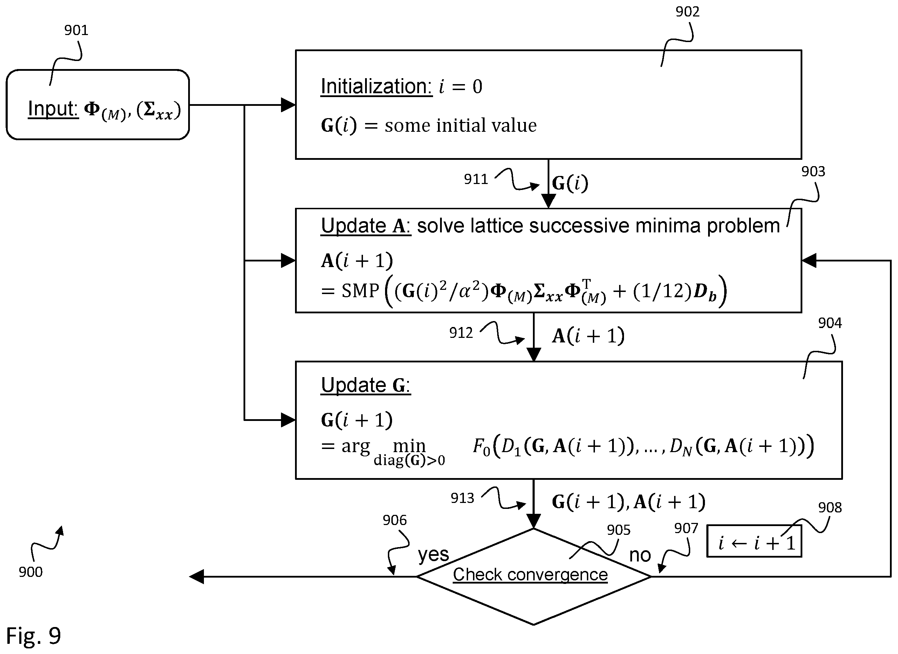

Fig. 9 shows a schematic diagram illustrating an exemplary procedure 900 that may be performed by the digital control block 480 of the ADC device 400 depicted in Figure 4.

As input 901, the mixing matrix $\Phi_{(M)}$ and optionally the input correlation matrix $\Sigma_{xx}$ is provided. In a first block 902 the weight matrix 911, $\mathbf{G}(i)$ is initialized to some initial value. In a second block 903, the matrix A is updated to updated matrix 912, $\mathbf{A}(i+1)$ by solving lattice successive minima problem as described above with respect to Figure 4:

$$\mathbf{A}(i+1) = \mathrm{SMP}\left((\mathbf{G}(i)^2/\alpha^2)\Phi_{(M)}\Sigma_{xx}\Phi_{(M)}^{\mathrm{T}} + (1/12)\boldsymbol{D_b}\right)$$

In a third block 904, the weight matrix G is updated according to:

$$\mathbf{G}(i+1) = \arg\min_{\mathrm{diag}(\boldsymbol{G})>0} \quad F_0\left(D_1(\boldsymbol{G},\mathbf{A}(i+1)), \dots, D_N(\boldsymbol{G},\mathbf{A}(i+1))\right)$$

After both updated matrices 913, $\mathbf{A}(i+1)$ and $\mathbf{G}(i+1)$ are obtained, in a fourth block 905, convergence is checked using any desired procedure or criterion. If there is no convergence 907, the procedure goes back for the next iteration 908 to the second block 903. If there is convergence 906, the procedure 900 is finished.

Fig. 10 shows a schematic diagram illustrating a general representation of an analog-to-digital converter (ADC) device 1000 according to the disclosure.

The ADC device 1000 comprises an analog mixer 1010, an analog-to-digital-converter 1020 and a digital estimator 1030.

The analog mixer 1010 is configured to correlate a first plurality (N) of analog input signals 401 based on a set of analog mixing parameters 1001 to provide a second plurality (M) of correlated analog signals 402, e.g. according to the description of Figures 4 to 9.

The analog-to-digital-converter 1020 is configured to convert the second plurality (M) of correlated analog signals 402 to a digital representation 405 of the second plurality of correlated analog signals 402 based on a set of modulo-ADC parameters 1002, e.g. according to the description of Figures 4 to 9.

The digital estimator 1030 is configured to convert the digital representation 405 of the second plurality of correlated analog signals 402 to a digital representation 406 of the first plurality (N) of analog input signals 401 based on the set of analog mixing parameters 1001 and the set of modulo-ADC parameters 1002, e.g. according to the description of Figures 4 to 9.

The set of modulo-ADC parameters 1002 is based on a correlation of the second plurality (M) of correlated analog signals 402, e.g. according to the description of Figures 4 to 9.

The set of analog mixing parameters 1001 may include the mixing matrix $\Phi_{(M)}$, as described above with respect to Figures 4 to 9. The set of modulo-ADC parameters 1002 may include the reconstruction matrix **A** and the matrix of amplifier gains, also referred to as weight matrix as described above with respect to Figures 4 to 9.

The ADC device 1000 can be seen as a general representation of the ADC device 400 described above with respect to Figure 4. The analog mixer 1010 corresponds to the analog mixing block 430, the analog-to-digital-converter 1020 may represent the modulo-ADC architecture 411 of Figure 4 and the digital estimator may represent the digital estimation algorithm 460 of Figure 4.

The second plurality (M) of correlated analog signals 402 can be larger than the first plurality (N) of analog input signals 401, e.g. as described above with respect to Figure 4.

The analog mixer 1010 may be configured to generate the second plurality (M) of correlated analog signals 402 based on linear combinations of the first plurality (N) of analog input signals 401 by using the set of analog mixing parameters 1001.

The set of modulo-ADC parameters 1002 may be based on a deviation of the digital representation 406 of the first plurality (N) of analog input signals 401 from the first plurality (N) of analog input signals 401.

The analog-to-digital-converter 1020 may be configured to process the second plurality (M) of correlated analog signals 402 based on a set of amplifier gains applied to the second plurality (M) of correlated analog signals 402, wherein the set of amplifier gains is based on the set of modulo-ADC parameters 1002.

The analog-to-digital-converter 1020 may be configured to process the second plurality (M) of correlated analog signals 402 based on a set of dither signals 605 applied to the amplified second plurality (M) of correlated analog signals 402, e.g. as described above with respect to Figure 6, wherein the set of dither signals 605 is generated by the analog-to-digital-converter 1020.

The analog-to-digital-converter 1020 may be configured to process each of the second plurality (M) of distorted amplified correlated analog signals 402 based on an analog modulo operation 603, e.g. as described above with respect to Figure 6, followed by a sampling 512 and quantization 513 operation, e.g. as described above with respect to Figure 5, to provide a second plurality (M) of quantization indices 404, e.g. as described above with respect to Figure 4.

The analog-to-digital-converter 1020 may be configured to process the second plurality (M) of quantization indices 404 based on a set of quantization codebooks 811 and a reconstruction matrix 814, e.g. as described above with respect to Figure 8, wherein the reconstruction matrix 814 is based on the set of modulo-ADC parameters 1002.

The analog-to-digital-converter 1020 may be configured to process the second plurality (M) of quantization indices 404 based on a set of modulo lattice operations, e.g. as described above with respect to Figure 4.

The analog-to-digital-converter 1020 may be configured to provide the digital representation 405 of the second plurality of correlated analog signals 402 based on a signal model of the first plurality (N) of analog input signals 401, wherein the signal model is based on the set of modulo-ADC parameters 1002, the set of analog mixing parameters 1001 and a quantization noise, e.g. as described above with respect to Figure 4.

The signal model may be a linear system specified as: $\mathbf{r}[\ell] \approx \mathbf{A}(\mathbf{G}\mathbf{y}[\ell] - \mathbf{z}[\ell]) = \mathbf{A}\mathbf{G}\Phi_{(M)}\mathbf{x}[\ell] - \mathbf{A}\mathbf{z}[\ell]$, e.g. as described above with respect to Figure 4, where $\mathbf{x}[\ell]$ denotes the first plurality (N) of analog input signals 401, $\mathbf{y}(l)$ denotes the second plurality (M) of correlated analog signals (402), $\mathbf{r}[\ell]$ denotes the digital representation 405 of the second plurality (M) of correlated analog signals 402, $\mathbf{z}[\ell]$ denotes the quantization noise, $\Phi_{(M)}$ denotes a mixing matrix, A denotes a reconstruction matrix and G denotes a matrix of amplifier gains.

The digital estimator 1030 may be configured to provide the digital representation 406 of the first plurality (N) of analog input signals 401 based on an inversion of the signal model of the first plurality (N) of analog input signals 401 provided by the analog-to-digital-converter 1020, e.g. as described above with respect to Figure 4.

The inversion of the signal model may be based on a minimum mean square error criterion using knowledge about statistics of the first plurality (N) of analog input signals 401 and statistics of the quantization noise, e.g. as described above with respect to Figure 4.

The matrix of amplifier gains and the reconstruction matrix may be based on the set of analog mixing parameters 1001, e.g. as described above with respect to Figure 4.

The matrix of amplifier gains and the reconstruction matrix may be based on a covariance matrix of the first plurality (N) of analog input signals 401, e.g. as described above with respect to Figure 4.

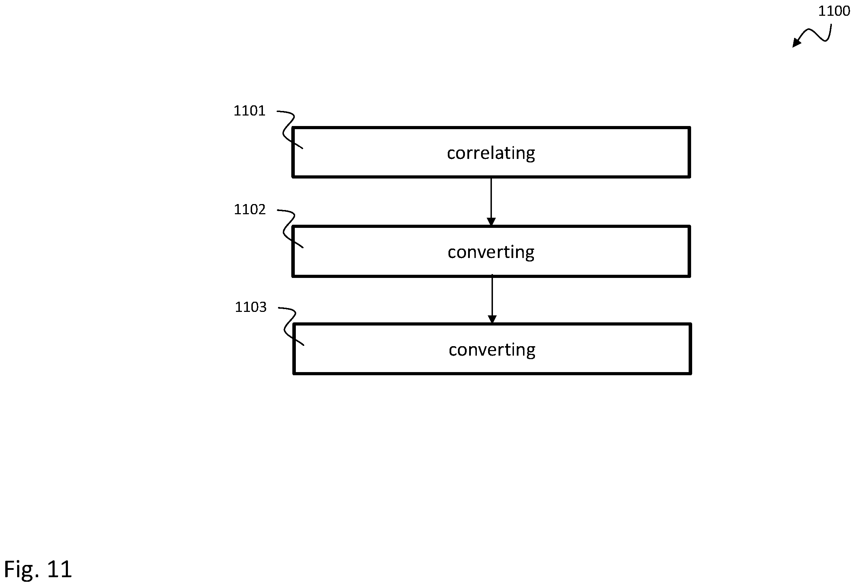

Fig. 11 shows a schematic diagram illustrating a method 1100 for analog-to-digital conversion according to the disclosure. The method 1100 may be applied, for example, with the disclosed ADC devices 400 and 1000 as described above with respect to Figures 4 to 10.

The method 1100 comprises: correlating 1101 a first plurality (N) of analog input signals 401 based on a set of analog mixing parameters 1001 to provide a second plurality (M) of correlated analog signals 402; converting 1102 the second plurality (M) of correlated analog signals 402 to a digital representation 405 of the second plurality of correlated analog signals 402 based on a set of modulo-ADC parameters 1002; converting 1103 the digital representation 405 of the second plurality of correlated analog signals 402 to a digital representation 406 of the first plurality (N) of analog input signals 401 based on the set of analog mixing parameters 1001 and the set of modulo-ADC parameters 1002; wherein the set of modulo-ADC parameters 1002 is based on a correlation of the second plurality (M) of correlated analog signals 402.

The second plurality (M) of correlated analog signals 402 may be larger than the first plurality (N) of analog input signals 401.

The method 1100 may further comprise: generating the second plurality (M) of correlated analog signals 402 based on linear combinations of the first plurality (N) of analog input signals 401 by using the set of analog mixing parameters 1001.

The set of modulo-ADC parameters 1002 may be based on a deviation of the digital representation 406 of the first plurality (N) of analog input signals 401 from the first plurality (N) of analog input signals 401.

The method 1100 may further comprise: providing the digital representation 405 of the second plurality of correlated analog signals 402 based on a signal model of the first plurality (N) of analog input signals 401, wherein the signal model is based on the set of modulo-ADC parameters 1002, the set of analog mixing parameters 1001 and a quantization noise, e.g. as described above with respect to Figures 4 to 10.

The signal model may be a linear system specified as: $\mathbf{r}[\ell] \approx \mathbf{A}(\mathbf{G}\mathbf{y}[\ell] - \mathbf{z}[\ell]) = \mathbf{A}\mathbf{G}\Phi_{(M)}\mathbf{x}[\ell] - \mathbf{A}\mathbf{z}[\ell]$, where $\hat{\mathbf{x}}[\ell]$ denotes the first plurality (N) of analog input signals (401), $\mathbf{y}[\ell]$ denotes the second plurality (M) of correlated analog signals (402), $\mathbf{r}[\ell]$ denotes the digital representation (405) of the second plurality (M) of correlated analog signals (402), $\mathbf{z}[\ell]$ denotes the quantization noise, $\mathbf{A}$ denotes a reconstruction matrix and $\mathbf{G}$ denotes a matrix of amplifier gains, e.g. as described above with respect to Figures 4 to 10.

The method 1100 may further comprise: providing the digital representation 406 of the first plurality (N) of analog input signals 401 based on an inversion of the signal model of the first plurality (N) of analog input signals 401.

The inversion of the signal model may be based on a minimum mean square error criterion using knowledge about statistics of the first plurality (N) of analog input signals 401 and statistics of the quantization noise, e.g. as described above with respect to Figures 4 to 10.

The matrix of amplifier gains and the reconstruction matrix may be based on the set of analog mixing parameters 1001, e.g. as described above with respect to Figures 4 to 10.

The matrix of amplifier gains and the reconstruction matrix may be based on a covariance matrix of the first plurality (N) of analog input signals 401, e.g. as described above with respect to Figures 4 to 10.

Figures 12a and 12b show exemplary performance diagrams of an ADC device according to the disclosure. Figure 12a shows results for uncorrelated input signals while Figure 12b shows results for correlated input signals. In Figure 12a, graph 1201 shows performance of the disclosed ADC architecture 400 for M ADCs of 6 bits, graph 1202 shows performance of the disclosed ADC architecture 400 for M ADCs of 7 bits and graph 1203 shows performance of the disclosed ADC architecture 400 for M ADCs of 8 bits. In Figure 12b, graph 1211 shows performance of the disclosed ADC architecture 400 for M ADCs of 6 bits, graph 1212 shows performance of the disclosed ADC architecture 400 for *M* ADCs of 7 bits and graph 1213 shows performance of the disclosed ADC architecture 400 for *M* ADCs of 8 bits.

In order to illustrate the advantages and beneficial effects of the novel ADC architecture presented in this disclosure, the performance of the disclosed ADC architecture and the performance of a conventional ADC have been compared through numerical simulations. Recognizing the difficulty in simulating a realistic ADC, a very simple mathematical model is adopted which still is able to capture features of the different ADC architectures.

In particular, the following architectures were implemented:

A) Conventional ADC Architecture 200: See Figure 2. ADC unit 210 with 4 mid-rise uniform symmetric quantizers 213 of *b* = {6, 8, 10, 12,14,16} bits and dynamic range [-1/2,1/2], 4 independent reconstruction blocks 221.

B) Modulo-ADC Architecture 300: See Figure 3. ADC unit 310 with 4 analog blocks 311 implemented according to the embodiment in Figure 6 and 4 mid-rise uniform symmetric quantizers 313 of *b* = {6, 7,8} bits and dynamic range [-1/2,1/2], joint digital reconstruction 321 implemented according to the embodiment in Figure 7, and digital control block 323 computing the modulo-ADC to minimize the sum of the reconstruction mean squared error.

C) Disclosed ADC Architecture 400: See Figure 4 and embodiments described with respect to Figure 4. In particular,

(i) the analog mixing block 430 follows the embodiment described above with respect to Figure 4 with the mixing matrix $\Phi_{(M)}$ being a random truncated unitary matrix;

(ii) the modulo-ADC block 411 follows the embodiment described above with respect to Figure 4, including a ADC unit 500 with *M* analog blocks 600 implemented according the embodiment in Figure 6 and M mid-rise uniform symmetric quantizers 513 of *b* = {6, 7, 8} bits and dynamic range [-1/2,1/2], joint digital reconstruction 800 implemented according to the embodiment in Figure 8;

(iii) the digital joint estimation block 460 follows the embodiment described above with respect to Figure 4 using the estimator in equation (18) assuming that $\Sigma_{xx} = I_4$;

(iv) the digital control block 480 follows the embodiment described above with respect to Figure 4, when the individual distortions are measured by the reconstruction mean squared error (see (15)) and the loss function is given by

$$F_0\big(D_1(\mathbf{G},\mathbf{A}), \dots, D_N(\mathbf{G},\mathbf{A})\big) = \sum_{n=1}^{N} D_n(\mathbf{G},\mathbf{A}) = \text{trace}(E\{|\boldsymbol{x}[\ell] - \widehat{\boldsymbol{x}}[\ell]|^2\}) \qquad (26)$$

assuming that $\Sigma_{xx} = I_4$. The modulo-ADC parameters are computed offline using the procedure illustrated in Figure 9 and kept constant for a given mixing matrix $\Phi_{(M)}$.

The accuracy the previous architectures is measured by the Signal-to-Quantization Noise Ratio when the analog input signals are generated as follows:

(a) Uncorrelated case: The input signal, $x_n(t)$, follows a Gaussian distribution with zero mean and unit variance for *n* = 1, ... , 4 and *t* = 1, 2, ... The input signals are uncorrelated: $E\{x_i(t)\, x_j(t)\} = 0$, for *i*, *j* = 1, ... 4 and *i* ≠ *j*.

(b) Correlated case: The input signal, $x_n(t)$, follows a Gaussian distribution with zero mean and unit variance for *n* = 1, ... , 4 and *t* = 1, 2, ... The input signals are correlated: $E\{x_i(t)\, x_j(t)\} = 0.7$, for *i*, *j* = 1, ... 4 and *i* ≠ *j*.

Figures 12(a) and 12(b) show the Signal-to-Quantization Noise Ratios (SQNRs) achieved by the previous ADC architectures when the analog signals are generated according to case (a) and (b), respectively.

After analyzing the simulations' results the following can be concluded:

The conventional ADC architecture 200 (see Figure 2) is ultimately limited by the accuracy of the individual ADCs. Increasing the bit resolution by 1 bit results approximately in a 6 dB gain in SQNR as expected.

The modulo-ADC architecture 300 (see Figure 3) uses individual ADCs with a resolution of 8 bits provides an effective accuracy of less than 6 bits. This fact was expected since the conditions required by modulo-ADC architecture 300 are not satisfied.

The disclosed ADC architecture 400 (see Figure 4) manages to generate the correlation required by the modulo-ADC unit 500 to outperform the conventional ADC architecture 200 and, thus, provide an effective resolution higher than the resolution of the individual ADCs used in the disclosed architecture. Increasing the number of individual ADCs (M) results in higher correlation and, thus, a higher effective accuracy. This statement is supported by the results in Figures 12(a) and 12(b).

The accuracy gains obtained by the disclosed ADC architecture 400 in Figures 12(a) and 12(b) come from particular combination of blocks in the disclosed invention and not only from increasing the number of individual ADCs. Increasing the number of ADCs in a conventional ADC architecture 200 from $N$ to $M$ using the disclosed analog mixing block results only in a SQNR gain of $M/(2N) \cdot 3$ dB.

The effective accuracy achieved by the disclosed ADC architecture 400 depends on the number of individual ADCs (M) and their resolution. For instance, using twice the number of individual ADCs as in the conventional ADC 200 (M = 8), results in an accuracy higher than 8 bits when using ADCs of 6 bits, higher than 10 bits when using ADCs of 7 bits, and higher than 13 bits when using ADCs of 8 bits. Recall that doubling the number of individual ADCs in a conventional ADC architecture 200 only increases the effective accuracy by 1/2 bit with respect to the nominal accuracy of the individual ADCs.

Given a target effective accuracy, the number of individual ADCs (M) depends the resolution of the individual ADCs. For instance, in order to achieve a target accuracy of 12 bits, either 12 ADCs of 6 bits, or 9 ADCs of 7 bits, or 8 ADCs of 8 bits are used.

By comparing the SQNR achieved by the disclosed ADC architecture 400 in Figures 12(a) and 12(b), one can conclude that the performance of the disclosed ADC architecture 400 is robust to the exact correlation of the analog inputs and does not require to estimate it. Recall that the embodiment adopted in the simulations computes all the parameters offline without assuming any statistical knowledge of the input signals.

The present disclosure also supports a computer program product including computer executable code or computer executable instructions that, when executed, causes at least one computer to execute the performing and computing steps described herein. Such a computer program product may include a readable non-transitory storage medium storing program code thereon for use by a computer. The program code may perform the processing and computing steps described herein.

While a particular feature or aspect of the disclosure may have been disclosed with respect to only one of several implementations, such feature or aspect may be combined with one or more other features or aspects of the other implementations as may be desired and advantageous for any given or particular application. Furthermore, to the extent that the terms "include", "have", "with", or other variants thereof are used in either the detailed description or the claims, such terms are intended to be inclusive in a manner similar to the term "comprise". Also, the terms "exemplary", "for example" and "e.g." are merely meant as an example, rather than the best or optimal. The terms "coupled" and "connected", along with derivatives may have been used. It should be understood that these terms may have been used to indicate that two elements cooperate or interact with each other regardless whether they are in direct physical or electrical contact, or they are not in direct contact with each other.

Although specific aspects have been illustrated and described herein, it will be appreciated by those of ordinary skill in the art that a variety of alternate and/or equivalent implementations may be substituted for the specific aspects shown and described without departing from the scope of the present disclosure. This application is intended to cover any adaptations or variations of the specific aspects discussed herein.

Although the elements in the following claims are recited in a particular sequence with corresponding labeling, unless the claim recitations otherwise imply a particular sequence for implementing some or all of those elements, those elements are not necessarily intended to be limited to being implemented in that particular sequence.

Many alternatives, modifications, and variations will be apparent to those skilled in the art in light of the above teachings. Of course, those skilled in the art readily recognize that there are numerous applications of the invention beyond those described herein. While the present invention has been described with reference to one or more particular embodiments, those skilled in the art recognize that many changes may be made thereto without departing from the scope of the present invention. It is therefore to be understood that within the scope of the appended claims the invention may be practiced otherwise than as specifically described herein.

## Claims

1. An analog-to-digital converter, ADC, device (1000), comprising:

an analog mixer (1010), configured to compute linear combinations of a first plurality (N) of analog input signals

(401) based on a set of analog mixing parameters (1001), which are multiplicative factors of the linear combinations, to provide a second plurality (*M*) of correlated analog signals (402);

an analog-to-digital-converter (1020) comprising a modulo-ADC unit (500), configured to convert the second plurality (M) of correlated analog signals (402) to a digital representation (405) of the second plurality of correlated analog signals (402) based on a set of modulo-ADC parameters (1002); and

a digital estimator (1030), configured to convert the digital representation (405) of the second plurality of correlated analog signals (402) to a digital representation (406) of the first plurality (N) of analog input signals (401) based on the set of analog mixing parameters (1001) and the set of modulo-ADC parameters (1002);

wherein the set of modulo-ADC parameters (1002) is based on a correlation of the second plurality (*M*) of correlated analog signals (402).

2. The ADC device (1000) of claim 1,
wherein the second plurality (M) of correlated analog signals (402) is larger than the first plurality *(N)* of analog input signals (401).

3. The ADC device (1000) of one of the preceding claims,
wherein the set of modulo-ADC parameters (1002) is based on a deviation of the digital representation (406) of the first plurality *(N)* of analog input signals (401) from the first plurality *(N)* of analog input signals (401).

4. The ADC device (1000) of one of the preceding claims,
wherein the analog-to-digital-converter (1020) is configured to process the second plurality (M) of correlated analog signals (402) based on a set of amplifier gains applied to the second plurality (M) of correlated analog signals (402), wherein the set of amplifier gains is based on the set of modulo-ADC parameters (1002).

5. The ADC device (1000) of claim 4,
wherein the analog-to-digital-converter (1020) is configured to process the second plurality (M) of correlated analog signals (402) based on a set of dither signals (605) applied to the amplified second plurality (M) of correlated analog signals (402), wherein the set of dither signals (605) is generated by the analog-to-digital-converter (1020).

6. The ADC device (1000) of claim 5,
wherein the analog-to-digital-converter (1020) is configured to process each of the second plurality (M) of dithered amplified correlated analog signals (402) based on an analog modulo operation (603) followed by a sampling (512) and quantization (513) operation to provide a second plurality (M) of quantization indices (404).

7. A method (1100) for analog-to-digital conversion, the method comprising:

compute linear combinations (1101) of a first plurality (N) of analog input signals (401) based on a set of analog mixing parameters (1001), which are multiplicative factors of the linear combinations, to provide a second plurality (M) of correlated analog signals (402);

converting (1102) the second plurality (M) of correlated analog signals (402) to a digital representation (405) of the second plurality of correlated analog signals (402) based on a set of modulo-ADC parameters (1002);

converting (1103) the digital representation (405) of the second plurality of correlated analog signals (402) to a digital representation (406) of the first plurality (N) of analog input signals (401) based on the set of analog mixing parameters (1001) and the set of modulo-ADC parameters (1002);

wherein the set of modulo-ADC parameters (1002) is based on a correlation of the second plurality (*M*) of correlated analog signals (402).

8. The method (1100) of claim 7,
wherein the second plurality (*M*) of correlated analog signals (402) is larger than the first plurality *(N)* of analog input signals (401).

9. The method (1100) of one of claims 7 to 8,
wherein the set of modulo-ADC parameters (1002) is based on a deviation of the digital representation (406) of the first plurality *(N)* of analog input signals (401) from the first plurality *(N)* of analog input signals (401).

10. The method (1100) of one of claims 7 to 9, comprising:
providing the digital representation (405) of the second plurality of correlated analog signals (402) based on a signal model of the first plurality (*N*) of analog input signals (401), wherein the signal model is based on the set of modulo-ADC parameters (1002), the set of analog mixing parameters (1001) and a quantization noise.

11. The method (1100) of claim 10,

   wherein the signal model is specified as:

$$r_m[\ell] = \begin{cases} \mathbf{a}_m^{\mathrm{T}}(\mathbf{G}\boldsymbol{y}[\ell] - \boldsymbol{z}[\ell]) & \text{with probability } \mathrm{Pr}(\mathbf{G}, \mathbf{a}_m) = \mathrm{Pr}\left(|\mathbf{a}_m^{\mathrm{T}}(\mathbf{G}\boldsymbol{y}[\ell] - \boldsymbol{z}[\ell])| \leq \frac{\alpha}{2}\right) \\ \tau_m[\ell] & \text{with probability } 1 - \mathrm{Pr}(\mathbf{G}, \mathbf{a}_m) \end{cases}$$

   $m = 1, \dots, M$
   where $\boldsymbol{y}[\ell]$ denotes the second plurality ($M$) of correlated analog signals (402), $\boldsymbol{r}[\ell] = [r_1[\ell], \dots, r_M[\ell]]^{\mathrm{T}}$ denotes the digital representation (405) of the second plurality ($M$) of correlated analog signals (402), $\boldsymbol{z}[\ell]$ denotes the quantization noise, $\mathbf{a}_m$ denotes a reconstruction vector, $\tau_m[\ell]$ denotes a random signal, $\alpha$ denotes a parameter range and $\mathbf{G}$ denotes a matrix of amplifier gains.

12. The method (1100) of claim 11, comprising:
   providing the digital representation (406) of the first plurality (N) of analog input signals (401) based on an inversion of the signal model of the first plurality (N) of analog input signals (401).

13. A computer program product comprising program code to perform the method according to any of claims 7 to 12, when executed by a computer.

**Patentansprüche**

1. Analog-Digital-Wandler-Vorrichtung, ADC-Vorrichtung, (1000), umfassend:

   einen Analog-Mischer (1010), der dazu konfiguriert ist, Linearkombinationen einer ersten Vielzahl *(N)* von analogen Eingangssignalen (401) basierend auf einem Satz von analogen Mischparametern (1001) zu berechnen, die Multiplikationsfaktoren der Linearkombinationen sind, um eine zweite Vielzahl (*M*) von korrelierten analogen Signalen (402) bereitzustellen;
   einen Analog-Digital-Wandler (1020), der eine Modulo-ADC-Einheit (500) umfasst, die dazu konfiguriert ist, die zweite Vielzahl (M) von korrelierten analogen Signalen (402) basierend auf einem Satz von Modulo-ADC-Parametern (1002) in eine digitale Darstellung (405) der zweiten Vielzahl von korrelierten analogen Signalen (402) umzuwandeln; und
   einen Digital-Schätzer (1030), der dazu konfiguriert ist, die digitale Darstellung (405) der zweiten Vielzahl von korrelierten analogen Signalen (402) basierend auf dem Satz von analogen Mischparametern (1001) und dem Satz von Modulo-ADC-Parametern (1002) in eine digitale Darstellung (406) der ersten Vielzahl (N) von analogen Eingangssignalen (401) umzuwandeln;
   wobei der Satz von Modulo-ADC-Parametern (1002) auf einer Korrelation der zweiten Vielzahl (*M*) von korrelierten analogen Signalen (402) basiert.

2. ADC-Vorrichtung (1000) nach Anspruch 1,
   wobei die zweite Vielzahl (*M*) von korrelierten analogen Signalen (402) größer ist als die erste Vielzahl *(N)* von analogen Eingangssignalen (401).

3. ADC-Vorrichtung (1000) nach einem der vorhergehenden Ansprüche,
   wobei der Satz von Modulo-ADC-Parametern (1002) auf einer Abweichung der digitalen Darstellung (406) der ersten Vielzahl (*N*) von analogen Eingangssignalen (401) von der ersten Vielzahl (*N*) von analogen Eingangssignalen (401) basiert.

4. ADC-Vorrichtung (1000) nach einem der vorhergehenden Ansprüche,
   wobei der Analog-Digital-Wandler (1020) dazu konfiguriert ist, die zweite Vielzahl (*M*) von korrelierten analogen Signalen (402) basierend auf einem Satz von Verstärkerverstärkungen, die an die zweite Vielzahl (M) von korrelierten analogen Signalen (402) angelegt werden, zu verarbeiten, wobei der Satz von Verstärkerverstärkungen auf dem Satz von Modulo-ADC-Parametern (1002) basiert.

5. ADC-Vorrichtung (1000) nach Anspruch 4,
wobei der Analog-Digital-Wandler (1020) dazu konfiguriert ist, die zweite Vielzahl (M) von korrelierten analogen Signalen (402) basierend auf einem Satz von Dithersignalen (605), die an die verstärkte zweite Vielzahl (M) von korrelierten analogen Signalen (402) angelegt werden, zu verarbeiten, wobei der Satz von Dithersignalen (605) durch den Analog-Digital-Wandler (1020) erzeugt wird.

6. ADC-Vorrichtung (1000) nach Anspruch 5,
wobei der Analog-Digital-Wandler (1020) dazu konfiguriert ist, jedes der zweiten Vielzahl (M) von geditherten, verstärkten, korrelierten Analogsignalen (402) basierend auf einer Analog-Modulo-Operation (603) zu verarbeiten, gefolgt von einer Abtastungs- (512) und Quantisierungsoperation (513), um eine zweite Vielzahl (M) von Quantisierungsindizes (404) bereitzustellen.

7. Verfahren (1100) zur Analog-Digital-Wandlung, wobei das Verfahren Folgendes umfasst:

Berechnen von Linearkombinationen (1101) einer ersten Vielzahl (N) von analogen Eingangssignalen (401) basierend auf einem Satz von analogen Mischparametern (1001), die Multiplikationsfaktoren der Linearkombinationen sind, um eine zweite Vielzahl (M) von korrelierten analogen Signalen (402) bereitzustellen;
Umwandeln (1102) der zweiten Vielzahl (M) von korrelierten analogen Signalen (402) in eine digitale Darstellung (405) der zweiten Vielzahl von korrelierten analogen Signalen (402) basierend auf einem Satz von Modulo-ADC-Parametern (1002);
Umwandeln (1103) der digitalen Darstellung (405) der zweiten Vielzahl von korrelierten analogen Signalen (402) in eine digitale Darstellung (406) der ersten Vielzahl (N) von analogen Eingangssignalen (401) basierend auf dem Satz von analogen Mischparametern (1001) und dem Satz von Modulo-ADC-Parametern (1002);
wobei der Satz von Modulo-ADC-Parametern (1002) auf einer Korrelation der zweiten Vielzahl (M) von korrelierten analogen Signalen (402) basiert.

8. Verfahren (1100) nach Anspruch 7,
wobei die zweite Vielzahl (M) von korrelierten analogen Signalen (402) größer ist als die erste Vielzahl (N) von analogen Eingangssignalen (401).

9. Verfahren (1100) nach einem der Ansprüche 7 bis 8,
wobei der Satz von Modulo-ADC-Parametern (1002) auf einer Abweichung der digitalen Darstellung (406) der ersten Vielzahl (N) von analogen Eingangssignalen (401) von der ersten Vielzahl (N) von analogen Eingangssignalen (401) basiert.

10. Verfahren (1100) nach einem der Ansprüche 7 bis 9, umfassend:
Bereitstellen der digitalen Darstellung (405) der zweiten Vielzahl von korrelierten analogen Signalen (402) basierend auf einem Signalmodell der ersten Vielzahl (N) von analogen Eingangssignalen (401), wobei das Signalmodell auf dem Satz von Modulo-ADC-Parametern (1002), dem Satz von analogen Mischparametern (1001) und einem Quantisierungsrauschen basiert.

11. Verfahren (1100) nach Anspruch 10,

wobei das Signalmodell wie folgt definiert ist:

$$r_m[\ell] = \begin{cases} \mathbf{a}_m^{\mathrm{T}}(\mathbf{G}\mathbf{y}[\ell] - \mathbf{z}[\ell]) & \text{mit einer Wahrscheinlichkeit von } \mathrm{Pr}(\mathbf{G}, \mathbf{a}_m) = \mathrm{Pr}\left(|\mathbf{a}_m^{\mathrm{T}}(\mathbf{G}\mathbf{y}[\ell] - \mathbf{z}[\ell])| \leq \frac{\alpha}{2}\right) \\ \tau_m[\ell] & \text{mit einer Wahrscheinlichkeit von } 1 - \mathrm{Pr}(\mathbf{G}, \mathbf{a}_m) \end{cases}$$

$m = 1, ..., M$
wobei $\mathbf{y}[\ell]$ die zweite Vielzahl (M) von korrelierten analogen Signalen (402) bezeichnet, $\mathbf{r}[\ell]=[r_1[\ell],..., r_M[\ell]]^{\mathrm{T}}$ die digitale Darstellung (405) der zweiten Vielzahl (M) von korrelierten analogen Signalen (402) bezeichnet, $\mathbf{z}[\ell]$ das Quantisierungsrauschen bezeichnet, $\mathbf{a}_m$ einen Rekonstruktionsvektor bezeichnet, $\tau_m[\ell]$ ein Zufallssignal bezeichnet, $\alpha$ einen Parameterbereich bezeichnet und $\mathbf{G}$ eine Matrix von Verstärkerverstärkungen bezeichnet.

12. Verfahren (1100) nach Anspruch 11, umfassend:
Bereitstellen der digitalen Darstellung (406) der ersten Vielzahl (N) von analogen Eingangssignalen (401) basierend auf einer Invertierung des Signalmodells der ersten Vielzahl (N) von analogen Eingangssignalen (401).

**13.** Computerprogrammprodukt, umfassend einen Programmcode, um das Verfahren nach einem der Ansprüche 7 bis 12 durchzuführen, wenn er durch einen Computer ausgeführt wird.

**Revendications**

**1.** Dispositif de convertisseur analogique-numérique, CAN, (1000), comprenant :

un mélangeur analogique (1010), configuré pour calculer des combinaisons linéaires d'une première pluralité ($N$) de signaux d'entrée analogiques (401) sur la base d'un ensemble de paramètres de mélange analogiques (1001), qui sont des facteurs multiplicatifs des combinaisons linéaires, pour fournir une seconde pluralité ($M$) de signaux analogiques corrélés (402) ;
un convertisseur analogique-numérique (1020) comprenant une unité modulo-CAN (500), configurée pour convertir la seconde pluralité ($M$) de signaux analogiques corrélés (402) en une représentation numérique (405) de la seconde pluralité de signaux analogiques corrélés (402) sur la base d'un ensemble de paramètres modulo-CAN (1002) ; et
un estimateur numérique (1030), configuré pour convertir la représentation numérique (405) de la seconde pluralité de signaux analogiques corrélés (402) en une représentation numérique (406) de la première pluralité ($N$) de signaux d'entrée analogiques (401) sur la base de l'ensemble de paramètres de mélange analogiques (1001) et de l'ensemble de paramètres modulo-CAN (1002) ;
dans lequel l'ensemble de paramètres modulo-CAN (1002) est basé sur une corrélation de la seconde pluralité ($M$) de signaux analogiques corrélés (402).

**2.** Dispositif CAN (1000) selon la revendication 1,
dans lequel la seconde pluralité ($M$) de signaux analogiques corrélés (402) est plus grande que la première pluralité ($N$) de signaux d'entrée analogiques (401).

**3.** Dispositif CAN (1000) selon l'une des revendications précédentes,
dans lequel l'ensemble de paramètres modulo-CAN (1002) est basé sur un écart de la représentation numérique (406) de la première pluralité ($N$) de signaux d'entrée analogiques (401) par rapport à la première pluralité ($N$) de signaux d'entrée analogiques (401).

**4.** Dispositif CAN (1000) selon l'une des revendications précédentes,
dans lequel le convertisseur analogique-numérique (1020) est configuré pour traiter la seconde pluralité (M) de signaux analogiques corrélés (402) sur la base d'un ensemble de gains d'amplificateur appliqués à la seconde pluralité ($M$) de signaux analogiques corrélés (402), dans lequel l'ensemble de gains d'amplificateur est basé sur l'ensemble de paramètres modulo-CAN (1002).

**5.** Dispositif CAN (1000) selon la revendication 4,
dans lequel le convertisseur analogique-numérique (1020) est configuré pour traiter la seconde pluralité ($M$) de signaux analogiques corrélés (402) sur la base d'un ensemble de signaux de tramage (605) appliqué à la seconde pluralité ($M$) amplifiée de signaux analogiques corrélés (402), dans lequel l'ensemble de signaux de vibration (605) est généré par le convertisseur analogique-numérique (1020).

**6.** Dispositif CAN (1000) selon la revendication 5,
dans lequel le convertisseur analogique-numérique (1020) est configuré pour traiter chacun de la seconde pluralité (M) de signaux analogiques corrélés amplifiés tramés (402) sur la base d'une opération modulo analogique (603) suivie d'une opération d'échantillonnage (512) et de quantification (513) pour fournir une seconde pluralité (M) d'indices de quantification (404).

**7.** Procédé (1100) de conversion analogique-numérique, le procédé comprenant :

le calcul de combinaisons linéaires (1101) d'une première pluralité (N) de signaux d'entrée analogiques (401) sur la base d'un ensemble de paramètres de mélange analogiques (1001), qui sont des facteurs multiplicatifs des combinaisons linéaires, pour fournir une seconde pluralité (M) de signaux analogiques corrélés (402) ;
la conversion (1102) de la seconde pluralité (M) de signaux analogiques corrélés (402) en une représentation numérique (405) de la seconde pluralité de signaux analogiques corrélés (402) sur la base d'un ensemble de paramètres modulo-CAN (1002) ;

la conversion (1103) de la représentation numérique (405) de la seconde pluralité de signaux analogiques corrélés (402) en une représentation numérique (406) de la première pluralité (N) de signaux d'entrée analogiques (401) sur la base de l'ensemble de paramètres de mélange analogiques (1001) et de l'ensemble de paramètres modulo-CAN (1002) ;

dans lequel l'ensemble de paramètres modulo-CAN (1002) est basé sur une corrélation de la seconde pluralité (*M*) de signaux analogiques corrélés (402).

8. Procédé (1100) selon la revendication 7,
dans lequel la seconde pluralité (M) de signaux analogiques corrélés (402) est plus grande que la première pluralité (N) de signaux d'entrée analogiques (401).

9. Procédé (1100) selon l'une des revendications 7 et 8,
dans lequel l'ensemble de paramètres modulo-CAN (1002) est basé sur un écart de la représentation numérique (406) de la première pluralité (N) de signaux d'entrée analogiques (401) par rapport à la première pluralité (N) de signaux d'entrée analogiques (401).

10. Procédé (1100) selon l'une des revendications 7 à 9, comprenant :
la fourniture de la représentation numérique (405) de la seconde pluralité de signaux analogiques corrélés (402) sur la base d'un modèle de signal de la première pluralité (N) de signaux d'entrée analogiques (401), dans lequel le modèle de signal est basé sur l'ensemble de paramètres modulo-CAN (1002), l'ensemble de paramètres de mélange analogiques (1001) et un bruit de quantification.

11. Procédé (1100) selon la revendication 10,

dans lequel le modèle de signal est spécifié comme suit :

$$r_m[\ell] = \begin{cases} \mathbf{a}_m^{\mathrm{T}}(\mathbf{G}\boldsymbol{y}[\ell] - \boldsymbol{z}[\ell]) & \text{avec la probabilité } \Pr(\mathbf{G}, \mathbf{a}_m) = \Pr\left(|\mathbf{a}_m^{\mathrm{T}}(\mathbf{G}\boldsymbol{y}[\ell] - \boldsymbol{z}[\ell])| \le \frac{\alpha}{2}\right) \\ \tau_m[\ell] & \text{avec la probabilité } 1 - \Pr(\mathbf{G}, \mathbf{a}_m) \end{cases}$$

$m = 1, \dots, M$
où $\mathbf{y}[\ell]$ désigne la seconde pluralité (*M*) de signaux analogiques corrélés (402), $\boldsymbol{r}[\ell] = [r_1[\ell], \dots, r_M[\ell]]^{\mathbf{T}}$ désigne la représentation numérique (405) de la seconde pluralité (*M*) de signaux analogiques corrélés (402), $\mathbf{z}[\ell]$ désigne le bruit de quantification, $\mathbf{a}_m$ désigne un vecteur de reconstruction, $\tau_m[\ell]$ désigne un signal aléatoire, $\alpha$ désigne une plage de paramètres et $\mathbf{G}$ désigne une matrice de gains d'amplificateur.

12. Procédé (1100) selon la revendication 11, comprenant :
la fourniture de la représentation numérique (406) de la première pluralité (*N*) de signaux d'entrée analogiques (401) sur la base d'une inversion du modèle de signal de la première pluralité (*N*) de signaux d'entrée analogiques (401).

13. Produit de programme informatique comprenant un code de programme pour réaliser le procédé selon l'une quelconque des revendications 7 à 12, lorsqu'il est exécuté par un ordinateur.

Fig. 1

Fig. 2

Fig. 3

Fig. 4

Fig. 5

Fig. 6

Fig. 7

Fig. 8

901

Input: $\mathbf{\Phi}_{(M)}, (\mathbf{\Sigma}_{xx})$

902

Initialization: $i = 0$

$\mathbf{G}(i) =$ some initial value

911 $\mathbf{G}(i)$

903

Update A: solve lattice successive minima problem

$\mathbf{A}(i + 1)$
$= \mathrm{SMP}\left((\mathbf{G}(i)^2/\alpha^2)\mathbf{\Phi}_{(M)}\mathbf{\Sigma}_{xx}\mathbf{\Phi}_{(M)}^{\mathrm{T}} + (1/12)\mathbf{D}_b\right)$

912 $\mathbf{A}(i + 1)$

904

Update G:

$\mathbf{G}(i + 1)$
$= \arg \min_{\mathrm{diag}(\mathbf{G})>0} F_0\big(D_1(\mathbf{G}, \mathbf{A}(i + 1)), \dots, D_N(\mathbf{G}, \mathbf{A}(i + 1))\big)$

913 $\mathbf{G}(i + 1), \mathbf{A}(i + 1)$

908

$i \leftarrow i + 1$

906 yes

905

907 no

Check convergence

900

Fig. 9

401

1010

402

1002

1000

$x_1(t)$

$x_2(t)$

$\vdots$

$x_N(t)$

ANALOG MIXER

$y_1(t)$

$y_2(t)$

$\vdots$

$y_M(t)$

1020

ADC

**G, A**

405

$\hat{r}_1[\ell]$ $\hat{r}_2[\ell]$ $\cdots$ $\hat{r}_M[\ell]$

1030

DIGITAL ESTIMATOR

406

$\hat{x}_1[\ell]$ $\hat{x}_2[\ell]$ $\cdots$ $\hat{x}_N[\ell]$

1001

$\mathbf{\Phi}_{(M)}$

Fig. 10

Fig. 11

Fig. 12a

Fig. 12b

EP 4 097 845 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 9667325 B1

**Non-patent literature cited in the description**

- **J. WEN** ; **L. LI** ; **X. TANG** ; **W. H. MOW** ; **C. TELLAMBURA**. An efficient optimal algorithm for integer-forcing linear MIMO receivers design. *2017 IEEE International Conference on Communications (ICC)*, 2017, 1-6
- **R. ZAMIR**. Lattice Coding for Signals and Networks. University Press, 2014
- **R. ZAMIR**. Lattice Coding for Signals and Networks. Cambridge. University Press, 2014